# EUROPEAN PATENT APPLICATION

(11) **EP 1 448 026 A1**
(43) Date of publication of application: **18.08.2004**
(21) Application number: 02802052.7
(22) Date of filing: 22.10.2002
(51) Int. Cl.: H05B 33/02, H05B 33/06, F21S 2/00

(54) **LIGHT EMITTING APPARATUS**

(30) Priority: 25.10.2001 JP 2001328150; 11.03.2002 JP 2002065356
(71) Applicant: Harison Toshiba Lighting Corp., Imabari-shi, Ehime 794-8510 (JP)
(72) Inventor: TANIGUCHI, Yoshio, Ueda-shi, Nagano 386-0012 (JP); OKI, Masahiro, HARISON TOSHIBA LIGHTING Corp., Imabari-shi, Ehime 794-8510 (JP); YOKOMIZO, Yuji, HARISON TOSHIBA LIGHTING Corp., Imabari-shi, Ehime 794-8510 (JP); OKADA, Shigeru, HARISON TOSHIBA LIGHTING Corp., Imabari-shi, Ehime 794-8510 (JP)
(74) Representative: Banzer, Hans-Jörg, Dipl.-Ing.
(86) International application number: PCT/JP2002/010956
(87) International publication number: WO 2003/037041

(57) **Abstract**

A light emitting apparatus having a large quantity of light per space necessary for installation, which allows easy adjustment of the directivity of light emission and easy arrangement of the color of emitted light and has a high light emitting efficiency, is achieved by a light emitting apparatus, which is comprised of a moisture impermeable substrate having a warped configuration, an electro-luminescent light emitting laminated body formed on the inner surface of the warped substrate having such constitution that, from the warped substrate side, at least a first electrode layer, a light emitting function layer and a second electrode layer being laminated in this order, a moisture impermeable opposing substrate joined in an impermeable manner at the edge portion or in a region adjacent to the edge portion of the warped substrate and electrical connection terminals connected to each of the electrode layers of the electro-luminescent light emitting laminated body for externally supplying electrical energy to each electrode layer.

## Description

### [Technical Field]

The present invention relates to a light emitting apparatus giving a large quantity of light per space required for installation, which allows easy adjustment of the directivity of the light emission and easy arrangement of the color of emitted light, and has a high light emitting efficiency.

### [Background Art]

On an instrument panel provided to a driver's seat of a vehicle, indicator lamps for indicating state of operation of various apparatus are equipped on the vehicle. As an example of the indicator lamps, an alarm lamp and the like, which indicate state of operation of a hand brake or a seat belt is given. Also, indicator lamps are employed for indicating state of operation of electric apparatus such as TV.

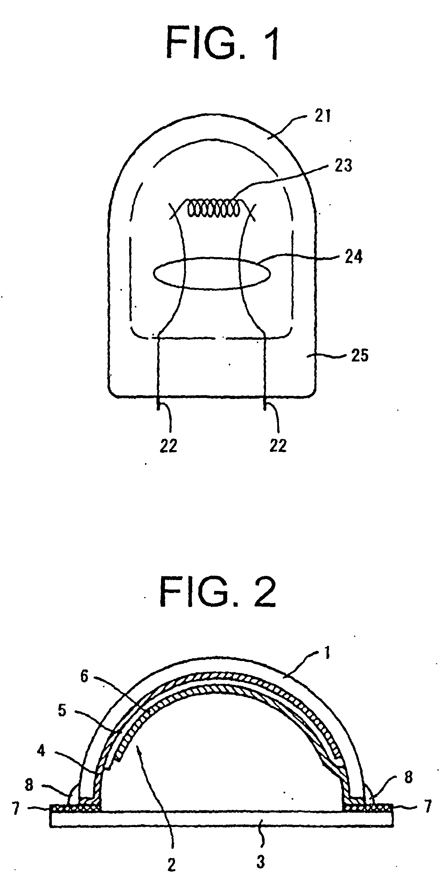

As for the light source of indicator lamps, small bulbs are widely used. Fig. 1 is a view showing the constitution of an example of a conventional small bulb. The small bulb comprises a pair of electrodes 22 provided to a glass bulb 21 in an airtight state, a filament 23 bridged between a pair of electrodes and the like. When electrical energy is supplied to the electrodes 22 and the filament 23 is heated to a high temperature, the small bulb emits light due to temperature radiant from the filament.

The indicator lamps are structured such that a part of a small glass bulb is allowed to come out toward the front side of the panel from an opening penetrating the instrument panel. Or a small bulb is disposed behind a light diffusion plate, a colored semitransparent plate, a lens or the like provided to the opening penetrating the panel.

The indicator lamp indicates two conditions of operation/non-operation of an apparatus by means of the state of lamp lighting/non-lighting. Accordingly, many indicator lamps are small in size. On the other hand, like the above mentioned alarm lamp, the indicator lamp is for drawing a certain attention of a person by means of lighting of the lamp. Accordingly, the indicator lamp is required to provide a satisfactory visibility so that the lighting of the lamp is easily recognized. For indicator lamps, a light source, which generates a large quantity of light of the light emitted from the light source, is preferred.

That is, as for the light source of indicator lamps, such light source that only a small space is required for installation and generates quantity of light as large as possible is preferred. A small bulb requires only a small space for installation but generates a large quantity of light, thus the small bulb is preferably employed as the light source for indicator lamps.

The small bulb generates a large quantity of light, and thus, provides a satisfactory visibility. However, since the heated filament emits the light, a large part of the electrical energy supplied to the bulb is converted into thermal energy or infrared light. Accordingly, the bulb has such problem that the light emitting efficiency is low. Further, in some cases, the indicator lamp is set with a color of the emitted light such as red, yellow, blue or the like based on the level of importance when drawing a person's attention. In such cases, the glass bulb of the lamp is colored. Or, the color of the emitted light is set by allowing the light emitted by the bulb to pass through a colored semitransparent material. When the color of the emitted light of the bulb is set as described above, visible light other than color of the emitted light is absorbed by the colored glass bulb and the like, thus the light emitting efficiency of the bulb is further lowered.

Furthermore, a driver visually recognizes the light emitted from an indicator lamp equipped on a vehicle. The small bulb used as the light source of an indicator lamp emits the light in all directions around the same. Accordingly, in the light emitted from the indicator lamp is not utilized effectively excepting the light, which proceeds to a direction where a driver resides in.

It is conceivable that the directivity of the light emission of the small bulb is adjusted so that the light emission is collected in the direction where a driver resides in to effectively utilize the same so as to enhance the visibility. However, it is difficult to adjust the directivity of the light emission of the small bulb. For example, it is conceivable that, in order to adjust the directivity of the light emission of the small bulb, the thickness of the glass bulb is adjusted to form a lens. However, when the thickness of the glass bulb is adjusted, due to the heat generated by the lighting of the small bulb, the glass bulb may be cracked. It is difficult to design the small glass bulb into such configuration so that the optical characteristic (directivity) is satisfied; and at the same time, the heat does not crack the glass bulb when the bulb is lit. It is conceivable to adjust the directivity of the light emitted from the small bulb by combining the small bulb with a lens. However, a lot of labor hour is required for designing the lens so as to satisfy the optical characteristic (directivity) and setting the distance between the small bulb and the lens.

On the other hand, as one of the light sources other than the bulb, an electro-luminescent element is known. Generally, the electro-luminescent element has such constitution that a positive electrode layer, a light emitting function layer including a luminous material, which generates fluorescence or phosphorescence, and a negative electrode layer are laminated. The electro-luminescent element is a self-luminous element, which emits light due to the emission of light (fluorescence, phosphorescence), which is generated in a manner as described below; that is, hole is injected from the positive electrode layer, and the electron is injected from the negative electrode layer into the light emitting function layer, and the hole and the electron are made to recombine with each other so as to generate exciter (exciton) in the light emitting function layer; and when the exciton is subjected to decay, the light is emitted. The electro-luminescent element has such advantages as superior in light emitting efficiency and easy to adjust the color of the emitted light by selecting luminous materials. Utilizing the above advantages, investigations of displays, which employ the electro-luminescent element, are actively persuaded. The electro-luminescent element employed in displays has flat shape.

It is conceivable that, by employing a flat shaped electro-luminescent element in place of a small bulb for indicator lamps, the color of the emitted light is easily adjustable, and the light emitting efficiency is also improved. However, when taking into consideration the case where an indicator lamp is used as alarm lamp, a light source, of which quantity of light is larger and is superior in visibility, is required.

As described above, the flat shaped electro-luminescent elements are investigated for applying mainly to displays. As for the performance of the display, the visibility of the indicated information (visual field angle etc), or precise repeatability of the color of the emitted light and the like are important. When a quantity of light (brightness) of a certain magnitude is obtained, it is acceptable as the flat shaped electro-luminescent element used for displays. On the contrary, when the quantity of light is too large (brightness is too high), when an operator carries out the operation for a long period of time while directly looking at the display, the operator tends to be readily tired. On the other hand, as for the indicator lamp, the light emission is not always looked at directly. Also, it is necessary to reliably draw the attention of the person by means of lighting of the lamp. Accordingly, it is preferred that the quantity of light of the light source of the indicator lamp is as large as possible.

It is an object of the present invention to provide a light emitting apparatus having a large quantity of light per space required for installation, which allows easy adjustment of the directivity of the light emission and easy arrangement of the color of emitted light, and has a high light emitting efficiency.

### [Disclosure of the Invention]

The inventors of the present invention have found the following fact; i.e., upon forming electro-luminescent light emitting laminated body on the inner surface of a moisture impermeable substrate with a warped configuration to constitute a light emitting apparatus; a large quantity of light per space necessary for installation of the light emitting apparatus can be obtained. Further, the inventors of the present invention have found the fact that, by setting the shape of the inner surface of the warped substrate, the directivity of the light emission of the light emitting apparatus can be easily adjusted. In such light emitting apparatus, since an electro-luminescent light emitting laminated body is employed as the light source thereof, the color of the emitted light can be easily set and a high light emitting efficiency is obtained.

The present invention is a light emitting apparatus, which is comprised of a moisture impermeable substrate having a warped configuration, an electro-luminescent light emitting laminated body formed on the inner surface of the warped substrate having such constitution that, from the warped substrate side, at least a first electrode layer, a light emitting function layer and a second electrode layer being laminated in this order, a moisture impermeable opposing substrate joined in an impermeable manner at the edge portion or in a region adjacent to the edge portion of the warped substrate and electrical connection terminals connected to each of the electrode layers of the electro-luminescent light emitting laminated body for externally supplying electrical energy to each electrode layer.

It is preferred that the light emitting apparatus of the present invention satisfies any of the following conditions (1) to (3).
(1) The warped substrate is transparent, the first electrode layer is transparent, the second electrode layer is transparent or opaque, and the opposing substrate is transparent or opaque.
(2) The warped substrate is transparent or opaque, the first electrode layer is transparent or opaque, the second electrode layer is transparent, and the opposing substrate is transparent.
(3) The warped substrate and the first electrode layer are constituted of a warped metal substrate, the second electrode layer is transparent, and the opposing substrate is transparent.

When the light emission of the electro-luminescent light emitting laminated body is output from the warped substrate side of the light emitting apparatus, the above condition (1) has to be satisfied; i.e., the warped substrate is transparent, and the first electrode layer is transparent. In this case, the second electrode layer and the opposing substrate may be transparent or opaque respectively.

When the light emission of the electro-luminescent light emitting laminated body is output from the opposing substrate side of the light emitting apparatus, the above condition (2) or (3) has to be satisfied; i.e., the second electrode layer is transparent, and the opposing substrate is transparent. To satisfy the condition (2), the warped substrate and the first electrode layer may be transparent or opaque respectively. To satisfy the condition (3), the warped substrate and the first electrode layer are constituted of a warped metal substrate.

In the light emitting apparatus, which satisfies the above condition (1), in order to output the light emission effectively from the warped substrate side of the light emitting apparatus, it is preferred that the second electrode layer is opaque and has the visible light reflecting property. Also, for example, when the light emitting apparatus of the present invention is used in place of a bulb for illumination, it is preferred that the second electrode layer is transparent, the visible light transmittance in the direction perpendicular to the laminated member of the electro-luminescent light emitting laminated body is 50% or more, and the opposing substrate is transparent. Further, for example, out of the light, which is emitted from the light emitting function layer of the electro-luminescent light emitting laminated body, when the light, which passes through the second electrode layer toward the opposing substrate, is output to the outside after being reflected toward the warped substrate side, it is preferred that the second electrode layer is transparent, the visible light transmittance in the direction perpendicular to the laminated member of the electro-luminescent light emitting laminated body is 50% or more, and the opposing substrate is opaque and has the visible light reflecting property.

In the light emitting apparatus, which satisfies the above condition (2), in order to output the light emission effectively, from the opposing substrate side of the light emitting apparatus, it is preferred that the first electrode layer is opaque and has the visible light reflecting property. Due to the same reason, it is also preferred that the warped substrate is opaque and has the visible light reflecting property. In this case, it is further preferred that the warped substrate is formed from a metal. To further adjust the directivity of the light, which is emitted from the electro-luminescent light emitting laminated body, it is preferred that, the opposing substrate is adjusted in the thickness thereof to form a convex lens or a concave lens.

Preferred modes of the light emitting apparatus that satisfies any of the above conditions (1) to (3) are as described below.
1) The inner surface of the warped substrate has a configuration including a part of a spherical surface, an elliptic surface or a parabolic surface.
2) The inner surface of the warped substrate has a half spherical surface.
3) Between the electro-luminescent light emitting laminated body and the opposing substrate, a vacuum space or a space filled with an inert gas is formed.
4) The electro-luminescent light emitting laminated body and the opposing substrate are in contact with each other.
5) The warped substrate and the opposing substrate have a joint portion respectively constituted of a metal or alloy composition in each edge portion or in a region adjacent to the edge portion, and these joint portions are welded to join to each other in an impermeable manner.
6) One of the electrical connection terminals that connect each of the first electrode layer and the second electrode layer of the electro-luminescent light emitting laminated body is provided to the joint portion between the warped substrate and the opposing substrate.
7) Both of the electrical connection terminals that connect each of the first electrode layer and the second electrode layer of the electro-luminescent light emitting laminated body are provided to the joint portion between the warped substrate and the opposing substrate.
8) One of the electrical connection terminals that connect each of the first electrode layer and the second electrode layer of the electro-luminescent light emitting laminated body is provided to an opening penetrating the warped substrate.
9) Both of the electrical connection terminals that connect each of the first electrode layer and the second electrode layer of the electro-luminescent light emitting laminated body are provided to the openings penetrating the warped substrate.
10) One of the electrical connection terminals that connect each of the first electrode layer and the second electrode layer of the electro-luminescent light emitting laminated body is provided to an opening penetrating the opposing substrate. Further preferably, the opposing substrate and the electrode layer of the electro-luminescent light emitting laminated body are joined via a conductive material layer.
11) Both of the electrical connection terminals that connect each of the first electrode layer and the second electrode layer of the electro-luminescent light emitting laminated body are provided to the openings penetrating the opposing substrate.

In this description, the wording "transparent" means that the transmittance of visible light is 70% or more; the wording "opaque" means that the transmittance of visible light is less than 70%; and the wording "visible light reflecting property" means that the reflectance of visible light is 70% or more.

### [Light emitting apparatus that satisfies the condition (1)]

Light emitting apparatus, which satisfies the above-mentioned condition (1), will be described using the attached drawings (Fig. 2 to Fig. 27).

Fig. 2 is a sectional view showing the constitution of an example of a light emitting apparatus in accordance with the present invention. The light emitting apparatus in Fig. 2 comprises a moisture impermeable substrate 1, which has a warped shape (referred to as warped substrate), an electro-luminescent (referred to as EL) light emitting laminated body 2, which is formed on the inner surface of the warped substrate 1, and a moisture impermeable opposing substrate 3 joined with the warped substrate 1 at the edge portion thereof in a moisture impermeable manner.

The EL light emitting laminated body 2 has such constitution that, from the warped substrate 1, a positive electrode layer (first electrode layer) 4, a light-emitting layer (light emitting function layer) 5 and a negative electrode layer (second electrode layer) 6 are laminated in this order. In order to output the light emission of the EL light emitting laminated body 2 from the warped substrate 1 side, the warped substrate 1 and the positive electrode layer 4 are transparent.

The light emitting apparatus is provided with conductive films 7, which are connected to each of a positive electrode layer 4 and a negative electrode layer 6 of the EL light emitting laminated body 2 as the electrical connection terminals for externally supplying electrical energy to each of the electrode layers. The positive electrode layer 4 (or the negative electrode layer 6) and the conductive film 7 are electrically connected being in contact with each other.

In the light emitting apparatus in Fig. 2, the EL light emitting laminated body 2 is formed on the inner surface of the warped substrate 1. Accordingly, the light emitting area (area of light emitting layer 5) of the EL light emitting laminated body per space (area of the opposing substrate 3), which is required for installation of the light emitting apparatus, can be made larger than that in the case where a plane-shaped EL light emitting element is employed as the light emitting apparatus. Consequently, the light emitting apparatus of the present invention generates a large quantity of light per space required for installation.

The configuration of the light emitting layer 5 of the EL light emitting laminated body 2 is of a configuration corresponding to the configuration of the inner surface of the warped substrate 1. Accordingly, by setting the configuration of the inner surface of the warped substrate 1, the directivity of light emission of the EL light emitting laminated body 2 can be easily adjusted. As shown in Fig. 2, in the light emitting apparatus, which satisfies the condition (1), the light emission is output from the outer surface of the concave light emitting layer 5 (surface at the positive electrode layer 4 side). Accordingly, the light emitting apparatus has a constitution suitable for adjusting the directivity of the light emission to be low.

In the light emitting apparatus in Fig. 2, since the EL light emitting laminated body 2 is employed as the light source thereof, the color of the emitted light can be directly set by selecting the luminous material used for the light emitting layer 5. Thus, in the light emitting apparatus of the present invention, different from the case of the bulb, color of the emitted light is not set in such manner that light emission of unnecessary color is removed. Therefore, light emitting efficiency is not reduced by the arrangement of the color of the emitted light.

In order to prevent the light emitting characteristics of the EL light emitting laminated body 2 from degrading (decrease in quantity of light of light emission or the like) due to the absorption of moisture, the warped substrate 1 is formed of a moisture impermeable material. And in order to output the light emission of the electro-luminescent light emitting laminated body 2 from the warped substrate side of the light emitting apparatus, the warped substrate 1 is formed from a transparent material.

The moisture permeability necessary for the warped substrate 1 varies depending on the use and environment of the light emitting apparatus. The warped substrate 1 has to have low moisture permeability to an extent that, when a durability test corresponding to the use and environment of the light emitting apparatus is carried out, the light emitting characteristics of the EL light emitting laminated body 2 are not degraded. Accordingly, the material for forming the warped substrate 1 is selected in an experimental manner based on the results of the above durability test and the like.

As an example of the material forming the warped substrate 1, a glass, a resin laminated with an impermeable layer or the like is available. As an example of the resin, polyethylene, polypropylene, polystyrene, polycarbonate and polyester are available. As an example of the impermeable layer, metal layer or metal oxide layer, which is formed on the surface of a resin molding having a warped configuration in a manner of evaporation or the like is available. It is desired that the impermeable layer be formed with a thin thickness to an extent that the visible light transmittance of the warped substrate is not reduced. The warped substrate 1 is preferably formed of glass. Since increasing the thickness thereof can reduce the moisture permeability of the warped substrate, the material for forming the warped substrate is not limited to the above-exemplified materials. The visible light transmittance of the warped substrate 1 is preferably 70% or more; further preferably 80% or more; and furthermore preferably 90% or more.

The directivity of the light emission of the light emitting apparatus in accordance with the present invention can be easily adjusted by setting the configuration of the inner surface of the warped substrate. It is preferred that the inner surface of the warped substrate has such configuration that includes a part of a spherical, ellipse or parabolic surface.

The inner surface of the warped substrate 1 of the light emitting apparatus in Fig. 2 is of a half spherical surface. The light emitting apparatus in Fig. 2 evenly emits the light around the warped substrate 1 (low in directivity). When the light emitting apparatus is looked at from any direction at the warped substrate side, the light emission thereof can be readily recognized. Accordingly, by allowing a part of the warped substrate of the light emitting apparatus of the present invention to protrude toward the front surface side from an opening penetrating the instrument panel, an indicator lamp superior in visibility can be constituted. Also, in the case where an indicator lamp is constituted in such manner that, for example, a plurality of light sources is disposed at the back surface of a light diffusion plate provided to an opening penetrating the instrument panel, by employing the light emitting apparatus of the present invention as the light source, unevenness of light intensity at the surface of the diffusion plate is reduced. Accordingly, the number of the light sources (light emitting apparatus) can be reduced.

The EL light emitting laminated body has such constitution that, from the warped substrate side, at least, the first electrode layer, the light emitting function layer and the second electrode layer being laminated in this order. The EL light emitting laminated body can be formed in the same manner as that of the plane-shaped EL light emitting element excepting the warped configuration thereof. The plane-shaped EL light emitting element is classified in the organic EL light emitting element and the inorganic EL light emitting element depending on the kind of the luminous material used for the light emitting function layer. It is preferred that the EL light emitting laminated body of the light emitting apparatus of the present invention is formed in the same manner as that of the plane-shaped organic EL light emitting element. As for the material for forming the plane-shaped organic EL light emitting element and the constitution of the layer of the organic EL light emitting element, detailed descriptions are given in "Remaining problems to be investigated and strategy for practical application of organic LED element" (BUN-SHIN Publishing, 1999), "Optical-electronic function organic material handbook" (ASAKURA PUBLISHING COMPANY, 1997) and the like.

The EL light emitting laminated body is formed by laminating, from the warped substrate side, the positive electrode layer (first electrode layer), the light emitting function layer and the negative electrode layer (second electrode layer) in this order; or by laminating the negative electrode layer (first electrode layer), the light emitting layer and the positive electrode layer (second electrode layer) in this order. In the light emitting apparatus, which satisfies the condition (1), in order to output the light emission of the EL light emitting laminated body from the warped substrate side of the light emitting apparatus, the first electrode layer is transparent. It is preferred that, same as the plane-shaped organic EL light emitting element, the first electrode layer at the warped substrate side is the positive electrode layer. Here, as an example, taking the case where the first electrode layer is the positive electrode layer as shown in Fig. 2, the EL light emitting laminated body will be described.

The positive electrode layer (first electrode layer) 4 is formed from a metal, an alloy composition, a conductive compound, mixture of the above or the like, which has a large work function (4eV or more). As an example of the material for forming the positive electrode layer, a metal such as gold and a transparent conductive compound of ITO (indium tin oxide), CuI, poly (3-methylthiophene), poly-thienylene vinylene, polyaniline and the like are available. For the positive electrode layer, nesa film of SnO₂, CdO, ZnO, TiO₂, In₂O₃ and the like may be employed. It is preferred that the positive electrode layer is formed from ITO.

The thickness of the positive electrode layer is generally in a range of 10nm to 1µm, preferably in a range of 50 to 200nm.

The visible light transmittance of the positive electrode layer is preferably 70% or more; further preferably 80% or more. The visible light transmittance of the positive electrode layer is adjustable by increasing/decreasing the thickness of the positive electrode layer. The resistance of the positive electrode layer is preferably less than several hundreds Ω/sq.

The light emitting function layer of the EL light emitting laminated body 2 shown in Fig. 2 is comprised of a single layered light emitting layer 5. The light emitting layer is formed from an organic light emitting material, or from a material in which an organic material having carrier transport characteristics (hole transport characteristic, electron transport characteristic, or bipolar transport characteristic) (referred to as host material) dosed with a small quantity of organic light emitting material. Selecting the organic light emitting material used for the light emitting layer can easily set the color of the emitting light.

In the case where the light emitting layer is formed from an organic light emitting material, as for the organic light emitting material, a material, which is superior in film forming performance and superior in stability of the film is selected. As an example of such organic light emitting material, a metal complex represented by Alq3 (tris (8-hydroxyquinolinato) aluminum), polyphenylene vinylene (PPV) derivatives, and polyfluorene derivatives and the like are available. As the organic light emitting material, which is used along with the host material, in addition to the above organic light emitting materials, a fluorescent dye or the like, which hardly forms stable thin film by itself due to small amount dosage, may be employed. As for an example of the fluorescent dye, coumarin, DCM derivatives, quinacridone, perylene, rubrene and the like are available. As for an example of the host material, the above Alq3, TPD (triphenyl diamine), oxadiazole derivatives (PBD) having electron transport characteristic, polycarbonate-based copolymer, polyvinyl carbazole and the like are available. Also, in the case where the light emitting layer is formed from the organic light emitting material, in order to adjust the color of the emitted light, a little amount of the organic light emitting material such as fluorescent dye may be added thereto.

The negative electrode layer (second electrode layer) 6 is formed from a metal, an alloy composition, a conductive compound, mixture of the above or the like, which has a small work function (less than 4eV). As an example of the material for forming the negative electrode layer, Na, K, Mg, Li, In, rare earth metal, Na-K alloy, Mg-Ag alloy, Mg-Cu alloy, Al-Li alloy, and Al/Al₂O₃ mixture are available.

The thickness of the negative electrode layer is generally in a range of 10nm to 1µm, preferably in a range of 50 to 200nm.

The negative electrode layer may be transparent or opaque. However, in order to effectively output the light emission of the organic EL light emitting laminated body 2 from the warped substrate 1 side of the light emitting apparatus, it is preferred that the negative electrode layer is opaque and has the visible light reflecting property. Accordingly, it is preferred that the negative electrode layer (second electrode layer) is formed from a metal or alloy composition. The resistance of the negative electrode layer is preferably less than several hundreds Ω/sq.

When the EL light emitting laminated body is formed in such constitution that, from the warped substrate side, the negative electrode layer (first electrode layer), the light emitting function layer, and the positive electrode layer (second electrode layer) being laminated in this order, the negative electrode layer is transparent. The visible light transmittance of the negative electrode layer is preferably 70% or more, more preferably 80% or more. The visible light transmittance of the negative electrode layer is adjustable by increasing/decreasing the thickness of the negative electrode layer. When increasing the visible light transmittance of the negative electrode layer, it is preferred that the thickness of the negative electrode layer is set to be less than 10nm, preferably in a range of 3 to 10nm, further preferably in a range of 3 to 8nm. In this case, the positive electrode layer (second electrode layer) may be transparent or opaque. However, further preferably, the positive electrode layer is opaque and has the visible light reflecting property.

In order to reduce the degradation in the light emitting characteristics of the EL light emitting laminated body 2 due to the absorption of moisture, the opposing substrate 3 is formed from a moisture impermeable material. The opposing substrate may be transparent or opaque.

The material for forming the transparent opposing substrate is the same as that for the warped substrate 1. As an example of material for forming opaque opposing substrate, a metal such as aluminum, iron, stainless steel and an alloy composition are available.

In order to reduce the moisture absorption of the EL light emitting laminated body 2, the opposing substrate 3 is joined in an impermeable manner at the edge portion of the warped substrate 1. In the light emitting apparatus in Fig. 2, the warped substrate 1 and the opposing substrate 3 are joined in an impermeable manner with a bonding agent 8. As an example of the bonding agent, a bonding agent from epoxy resin, a bonding agent from acrylic resin and the like are available. In order to prevent the material constituting the EL light emitting laminated body from being degenerated due to the heat, it is preferred that the bonding agent is of a room temperature curing type or an ultraviolet curing type.

As shown in Fig. 2, when the bonding agent 8 is applied to the periphery of the joined region between the warped substrate 1 and the opposing substrate 3, a large amount of the bonding agent is applied thereto. Thereby, it is possible to reduce the amount of the moisture that permeates the joined region between the warped substrate and the opposing substrate into the inside of the light emitting apparatus.

In the light emitting apparatus of the present invention, in order to reduce the moisture absorption of the EL light emitting laminated body 2, it is preferred that a vacuum space or a space filled with inert gas is provided between the EL light emitting laminated body 2 and the opposing substrate 3. To achieve this, the warped substrate and the opposing substrate may be joined in a vacuum or inert gas. Further, an exhaust pipe may be provided to the opposing substrate before hand, and after the warped substrate and the opposing substrate are joined each other, the air including moisture in the space, which is formed by the warped substrate and the opposing substrate, is exhausted therefrom; and then, the exhaust pipe may be welded to seal the same. Or, the air may be exhausted in the same manner as the above, and after filling the space with inert gas such as argon, nitrogen or the like, the exhaust pipe may be welded to seal the same. To remove the moisture from the space formed by the warped substrate and the opposing substrate, it is enough that the warped substrate and the opposing substrate are joined in an impermeable manner. Further, the above may be joined into a complete airtight state.

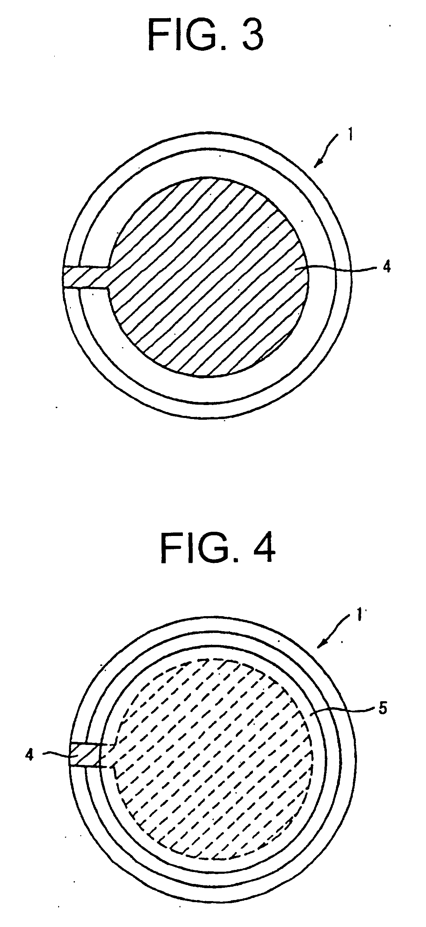

Fig. 3 is a bottom view of the warped substrate 1 in which the positive electrode layer (first electrode layer) 4 has been formed in the fabricating process of the light emitting apparatus in Fig. 2. As shown in Fig. 3, the positive electrode layer 4 is formed on the inner surface of the warped substrate 1. In order to be electrically connected to the conductive film (electrical connection terminal) formed on the opposing substrate, a part of the pattern of the positive electrode layer 4 is extended to the edge portion of the warped substrate 1. The pattern of the positive electrode layer 4 is set in the following manner; i.e., a metal foil is attached to a portion where the positive electrode layer of the warped substrate 1 is not formed, and on the inner surface of the warped substrate attached with the metal foil, a thin film from a material for forming the above positive electrode layer is formed; and then, the metal foil is removed. Also, in place of the metal foil, a mask of a metal plate having a configuration along the inner surface of the warped substrate, in which an opening is formed in a pattern of the positive electrode layer, may be used. As an example of forming method of the positive electrode layer, vacuum evaporation, DC sputtering, RF sputtering, spin coating, casting, LB method and the like are available.

Fig. 4 is a bottom view of the warped substrate 1 in which, next to the positive electrode layer 4, the light emitting layer (light emitting function layer) 5 has been formed in the fabricating process of the light emitting apparatus in Fig. 2. As shown in Fig. 4, the light emitting layer 5 is formed so as to cover substantially all over the positive electrode layer 4 so that the positive electrode layer 4 is prevented from coming into contact with the negative electrode layer, which is formed later. The pattern of the light emitting layer 5 may be set in the same manner as the positive electrode layer. As an example of the forming method of the light emitting layer, vacuum evaporation, spin coating, casting, LB method and the like are available.

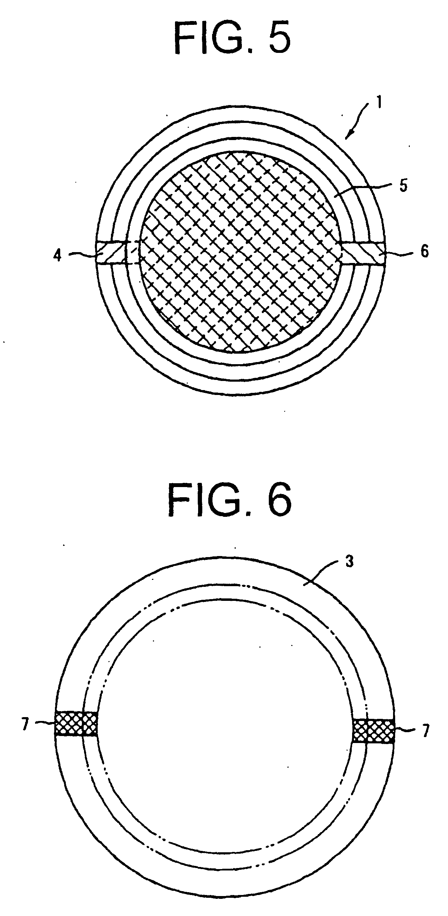

Fig. 5 is a bottom view of the warped substrate 1 in which, next to the light emitting layer 5, the negative electrode layer (second electrode layer) 6 has been formed in the fabricating process of the light emitting apparatus in Fig. 2. As shown in Fig. 5, the negative electrode layer 6 is formed with a pattern, which does not overlap with the exposed portion of the positive electrode layer so as to prevent from coming into contact with the positive electrode layer 4. The setting methods of the pattern of the negative electrode layer 6 and the forming method of the negative electrode layer are the same as those of the positive electrode layer. Thus, the EL light emitting laminated body is formed on the inner surface of the warped substrate 1.

Fig. 6 is a plan view of the opposing substrate 3 in which the conductive films 7 (electrical connection terminals) have been formed in the fabricating process of the light emitting apparatus in Fig. 2. The conductive films 7 (electrical connection terminals) are formed from a conductive material. As an example of the conductive material, metal materials such as the material for forming the above positive electrode layer or negative electrode layer, aluminum, copper, silver and the like are available. Also, the forming method of the conductive film is the same as that of the positive electrode layer. In the case where the opposing substrate 3 has a plane shape, the pattern of the conductive film 7 is set by means of a known method (masking, making photolithography or the like). And then, at the position of the opposing substrate 3 indicated by the two-dot chain lines shown in Fig. 6, the edge portion of the warped substrate, which has been formed with the EL light emitting laminated body is placed thereon, and joined in an impermeable manner with an bonding agent on the periphery of the joint portion; thus the light emitting apparatus in Fig. 2 is obtained.

In order to enhance the light emitting efficiency and increase the injecting efficiency of the carrier (hole or electron) to the light emitting layer, it is preferred that the light emitting function layer of the EL light emitting laminated body is constituted of the light emitting layer and the hole transport layer and/or electron transport layer formed being in contact with the light emitting layer.

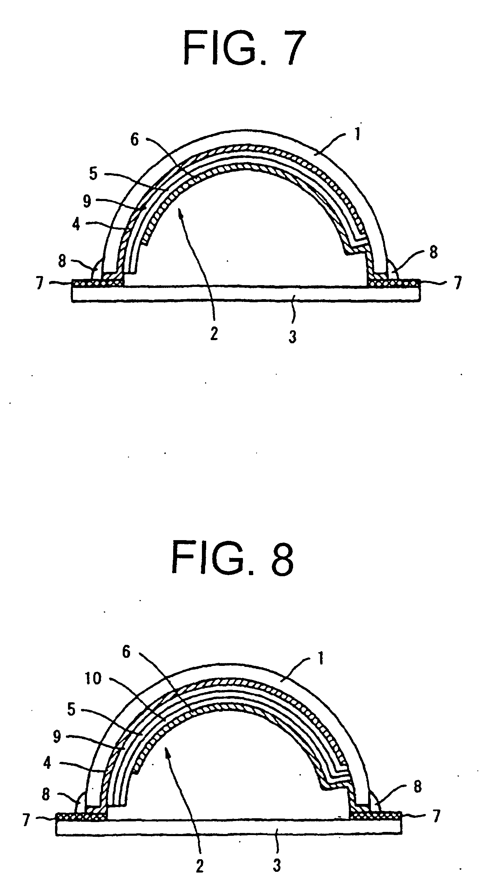

Fig. 7 is a sectional view showing the constitution of another example of the light emitting apparatus in accordance with the present invention. The EL light emitting laminated body 2 of the light emitting apparatus in Fig. 7 has such constitution that, from the warped substrate 1 side, the positive electrode layer 4, the hole transport layer 9, the light emitting layer 5 and the negative electrode layer 6 are laminated in this order.

Fig. 8 is a sectional view showing the constitution of another example of the light emitting apparatus in accordance with the present invention. The EL light emitting laminated body 2 of the light emitting apparatus in Fig. 8 has such constitution that, from the warped substrate 1 side, the positive electrode layer 4, the hole transport layer 9, the light emitting layer 5, an electron transport layer 10 and the negative electrode layer 6 are laminated in this order.

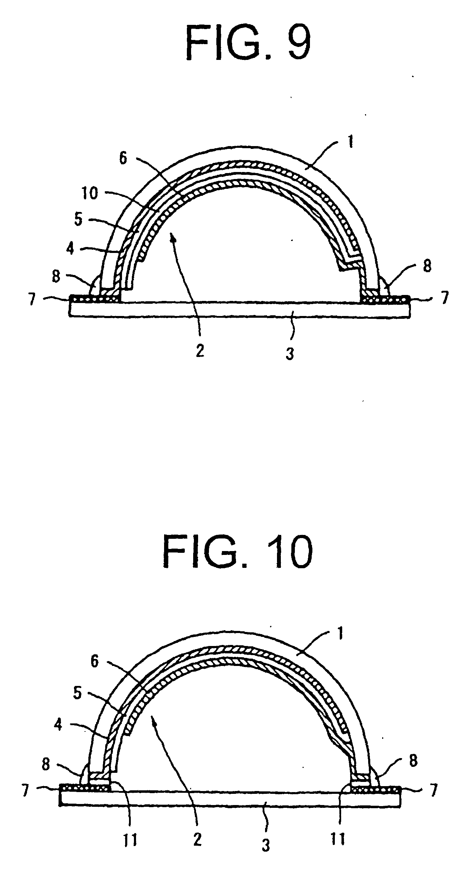

Fig. 9 is a sectional view showing the constitution of another example of the light emitting apparatus in accordance with the present invention. The EL light emitting laminated body 2 of the light emitting apparatus in Fig. 9 has such constitution that, from the warped substrate 1 side, the positive electrode layer 4, the light emitting layer 5, the electron transport layer 10 and the negative electrode layer 6 are laminated in this order.

The hole transport layer 9 has a function to transport the hole from the positive electrode layer 4 and injects the same effectively into the light emitting layer 5; thereby enhances the light emitting efficiency of the EL light emitting laminated body 2.

As an example of the material for forming the hole transport layer, hole-transporting materials such as tetraarylbenzidine compound, aromatic amines, pyrazoline derivatives, and triphenylene derivatives are available. It is preferred that tetraphenyldiamine (TPD) is employed as the hole transporting material.

The thickness of the hole transport layer is preferably in a range of 2 to 200nm. The hole transport layer is formed in the same manner as the light emitting layer.

In order to improve the hole transport characteristics such as hole mobility, the hole transport layer is preferably dosed with an electron acceptable adapter. As an example of the electron acceptable adapter, halogenated metals, Lewis acids, organic acids and the like are available. Japanese Unexamined Patent Publication No. 11-283750 discloses the hole transport layer dosed with the electron acceptable adapter.

When the hole transport layer is dosed with the electron acceptable adapter, the thickness of the hole transport layer is preferably in a range of 2 to 5000nm.

The electron transport layer 10 has a function to transport the electron from the negative electrode layer 6 and inject the same effectively into the light emitting layer 5; thereby enhance the light emitting efficiency of the EL light emitting laminated body 2.

As an example of the material for forming the electron transport layer, electron transporting materials such as nitro-substituted fluorene derivatives, diphenylquinone derivatives, thiopyran dioxide derivatives, heterocyclic tetracarboxylic acid anhydrates such as naphthalene pyrilene, carbodiimide, fluorenyliden methane derivatives, anthraquinone dimethane and anthrone derivatives, oxadiazole derivatives, thiadiazole derivatives formed by replacing an oxyzen atom in an oxadiazole ring of oxadiazole derivtives by a sulfur atom, quinoline derivatives, quinoxaline derivatives, perylene derivative, pyridine derivatives, pyrimidine derivatives, and stilbene derivatives are available. Also, alumiquinolinol complexes such as tris (8-hydroxyquinoline) aluminum (Alq) may be employed.

The thickness of the electron transport layer is preferably in a range of 5 to 300nm. The electron transport layer may be formed in the same manner as the light emitting layer.

When the light emitting apparatus of the present invention is used in place of a small bulb as described above, to dispose the light emitting apparatus with a satisfactory positional accuracy, the forming method of the electrical connection terminal, which supplies the electrical energy to the light emitting apparatus, is also important. The forming method of the electrical connection terminal will be described.

In the light emitting apparatus of the present invention, it is preferred that either or both of the electrical connection terminals are provided at the joint portion between the warped substrate and the opposing substrate. In the light emitting apparatus in Fig. 2, both of the electrical connection terminals (conductive film 7) are provided at the joint portion between the warped substrate 1 and the opposing substrate 3. The positive electrode layer 4 (or negative electrode layer 6) and the conductive film 7 are in contact with each other; thus both are electrically connected to each other.

Fig. 10 is a sectional view showing the constitution of another example of the light emitting apparatus in accordance with the present invention. The constitution of the light emitting apparatus in Fig. 10 is the same as that of the light emitting apparatus in Fig. 2 excepting the following point; i.e., each of the electrode layers and the conductive film 7 are electrically connected to each other via a conductive bonding material 11. By employing the conductive bonding material 11, satisfactory electrical connection between each of the electrode layers and the conductive film 7 is obtained. As an example of the conductive bonding material 11, a conductive bonding agent, which is a binder resin densely filled with a conductive filler, an anisotropic conductive film, an anisotropic conductive paste, a silver paste, a copper paste and the like are available. When the moisture permeability of the conductive bonding material 11 is satisfactorily low, a bonding agent 8 for reducing the moisture permeability as a part of the conductive bonding material 11 is not necessary.

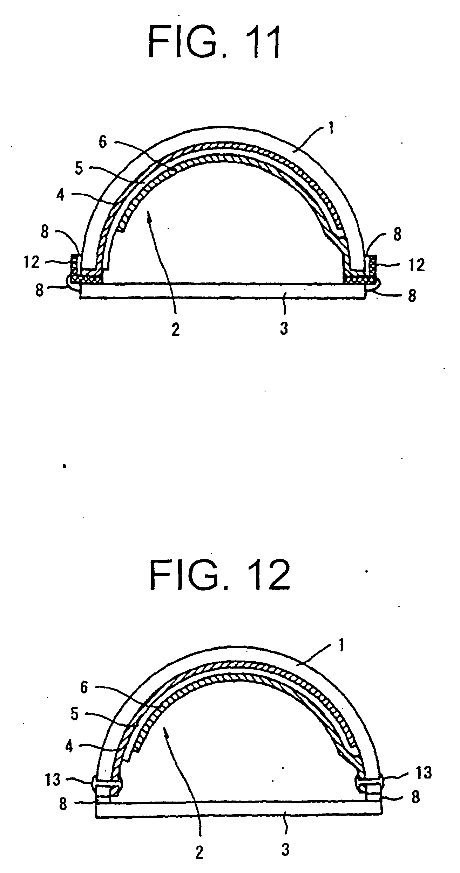

Fig. 11 is a sectional view showing the constitution of another example of the light emitting apparatus in accordance with the present invention. The constitution of the light emitting apparatus in Fig. 11 is the same as that of the light emitting apparatus in Fig. 2 excepting the following point; i.e., metal foils 12, which are provided to the joint portion between the warped substrate 1 and the opposing substrate 3, are employed as the electrical connection terminals. The positive electrode layer 4 (or negative electrode layer 6) and the metal foils 12 used as the electrical connection terminals are in contact with each other; thus the both are electrically connected to each other. The positive electrode layer 4 (or negative electrode layer 6) and the metal foils 12 may be electrically connected via a conductive bonding material same as the light emitting apparatus in Fig. 10.

In the light emitting apparatus in Fig. 2 to Fig. 11, both of the electrical connection terminals are provided to the joint portion between the warped substrate and the opposing substrate. When the light emitting apparatus having the constitution as described above is disposed on the surface of a support board (for example, print circuit board) with the opposing substrate as the base, the light emitting apparatus has such advantage that the position in the high direction of light emitting apparatus can be set precisely.

In the light emitting apparatus of the present invention, either or both of the electrical connection terminals are also preferably provided to openings, which penetrate the warped substrate.

Fig. 12 is a sectional view showing the constitution of another example of the light emitting apparatus in accordance with the present invention. In the light emitting apparatus in Fig. 12, after the EL light emitting laminated body 2 has formed on the inner surface of the warped substrate 1, openings, which penetrate the warped substrate, are formed. As the electrical connection terminals, conductive terminals 13 of metal or the like are attached to these openings. In the case where the warped substrate 1 and the opposing substrate 3 are joined via the bonding agent 8 as the case of the light emitting apparatus in Fig. 12, by applying the bonding agent thinly in thickness, it is possible to reduce the amount of the moisture, which enters into the inside of the light emitting apparatus through the joint portion between the warped substrate and the opposing substrate.

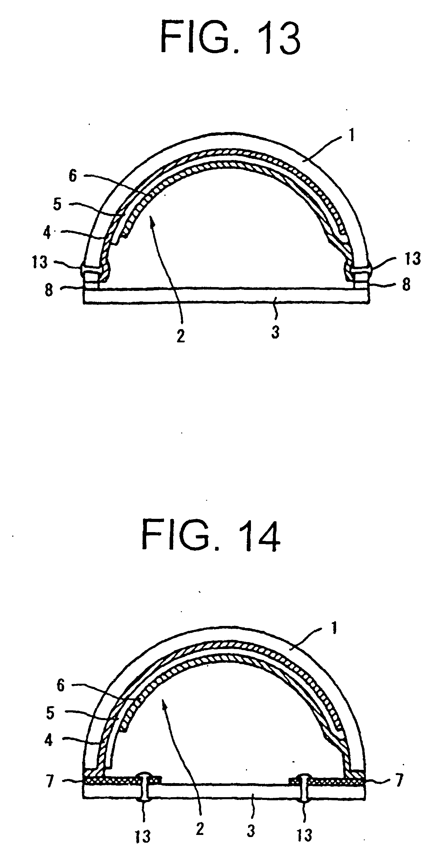

Fig. 13 is a sectional view showing the constitution of another example of the light emitting apparatus in accordance with the present invention. In the light emitting apparatus in Fig. 13, before the EL light emitting laminated body 2 is formed on the inner surface of the warped substrate 1, openings, which penetrate the warped substrate, are formed. And conductive terminals 13 are attached to these openings. The EL light emitting laminated body 2 is formed on the inner surface of the warped substrate 1 so that the conductive terminals 13 and each of the electrode layers are connected electrically to each other.

The light emitting apparatus, which have the constitutions shown in Fig. 12 and Fig. 13, same as the light emitting apparatus shown in Fig. 2 to Fig. 11, have such advantage that the position in the height direction of the light emitting apparatus can be set precisely. Also, the light emitting apparatus, which have the constitutions as described above, have such advantage that the electrical energy can be readily supplied to the light emitting apparatus only by inserting the light emitting apparatus into a cylindrical socket (not shown) for supplying the electrical energy to the conductive terminals 13 (electrical connection terminals).

In the light emitting apparatus of the present invention, it is also preferred that either one or both of the electrical connection terminals are provided to the openings, which penetrate the opposing substrate.

Fig. 14 is a sectional view showing the constitution of another example of the light emitting apparatus in accordance with the present invention. In the light emitting apparatus in Fig. 14, the conductive terminals 13 is provided to the openings, which penetrate the opposing substrate 3, as the electrical connection terminals. Each of the electrode layers and the conductive terminals 13 are electrically connected to each other via the conductive film.

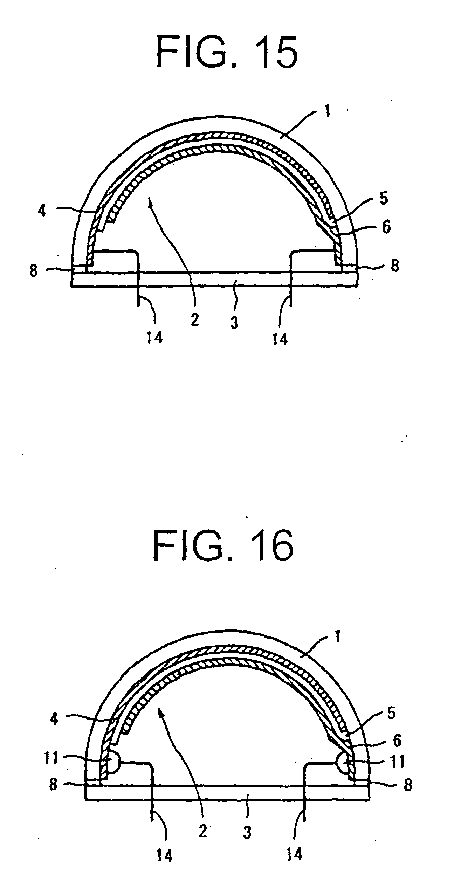

Fig. 15 is a sectional view showing the constitution of another example of the light emitting apparatus in accordance with the present invention. In the light emitting apparatus shown in Fig. 15, lead wires 14 are provided to the openings, which penetrate the opposing substrate 3, as the electrical connection terminals. Each of the electrode layers and the lead wires are electrically connected to each other being in contact with each other.

Fig. 16 is a sectional view showing the constitution of another example of the light emitting apparatus in accordance with the present invention. The constitution of the light emitting apparatus in Fig. 16 is the same as that of the light emitting apparatus in Fig. 15 excepting the point that the lead wires 14 and each of the electrode layers are electrically connected via a conductive bonding material 11.

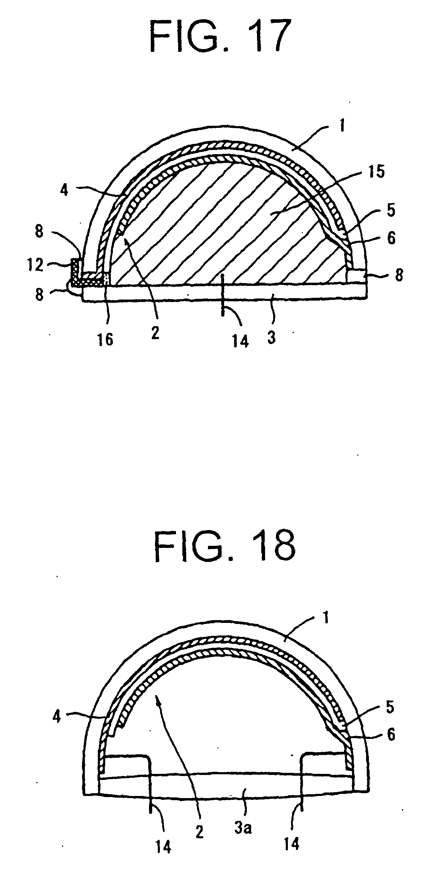

Fig. 17 is a sectional view showing the constitution of another example of the light emitting apparatus in accordance with the present invention. In the light emitting apparatus in Fig. 17, a lead wire 14 is provided to an opening, which penetrates the opposing substrate 3, as the electrical connection terminal of the negative electrode layer 6. The opposing substrate 3 and the EL light emitting laminated body 2 are joined with each other via the conductive material layer 15. The negative electrode layer 6 of the EL light emitting laminated body 2 and the lead wire 14 are electrically connected via the conductive material layer 15. As for the electrical connection terminal of the positive electrode layer 4, a metal foil 12, which is provided to the joint portion between the warped substrate 1 and the opposing substrate 3, is used. And in order to prevent the positive electrode layer 4 and the conductive material layer 15 from being electrically connected to each other, an insulating material layer 16 is formed therebetween.

As an example of the material for forming the conductive material layer 15, a metal fiber and a conductive resin and the like are available. As an example of the material for forming the metal fiber, metals such as iron, aluminum and copper are available. As an example of the conductive resin, polyacetylene, polyaniline, polyparaphenylene, polythiophene and the like are available. Further, resins dosed with metal powder are also included in the conductive resin.

Fig. 18 is a sectional view showing the constitution of another example of the light emitting apparatus in accordance with the present invention. The constitution of the light emitting apparatus in Fig. 18 is the same as that of the light emitting apparatus in Fig. 15 excepting the point that the opposing substrate 3a is joined to the warped substrate 1 by welding in a region adjacent to the edge portion thereof.

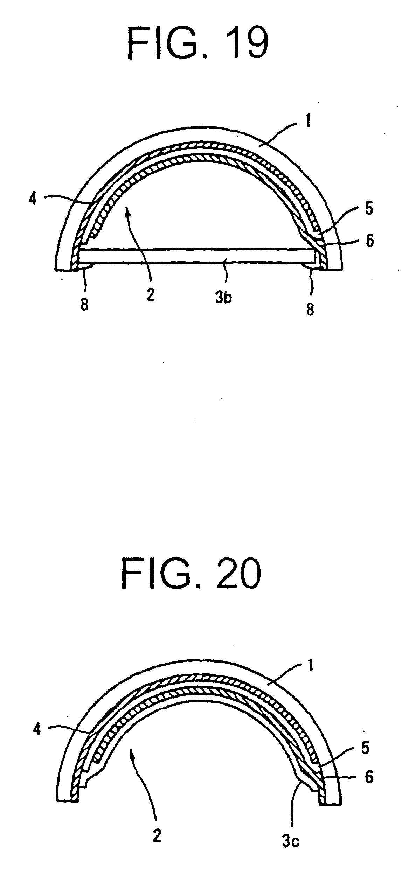

Fig. 19 is a sectional view showing the constitution of another example of the light emitting apparatus in accordance with the present invention. In the light emitting apparatus in Fig. 19, the opposing substrate 3b is joined to the warped substrate 1 in a region adjacent to the edge portion by means of a bonding agent.

Fig. 20 is a sectional view showing the constitution of another example of the light emitting apparatus in accordance with the present invention. In the light emitting apparatus in Fig. 20, the EL light emitting laminated body 2 and the opposing substrate 3c are in contact with each other. As for the electrical connection terminals of the light emitting apparatus in Fig. 20, the positive electrode layer 4 and the negative electrode layer 6, which are provided in the joint portion between the warped substrate 1 and the opposing substrate 3c, are used.

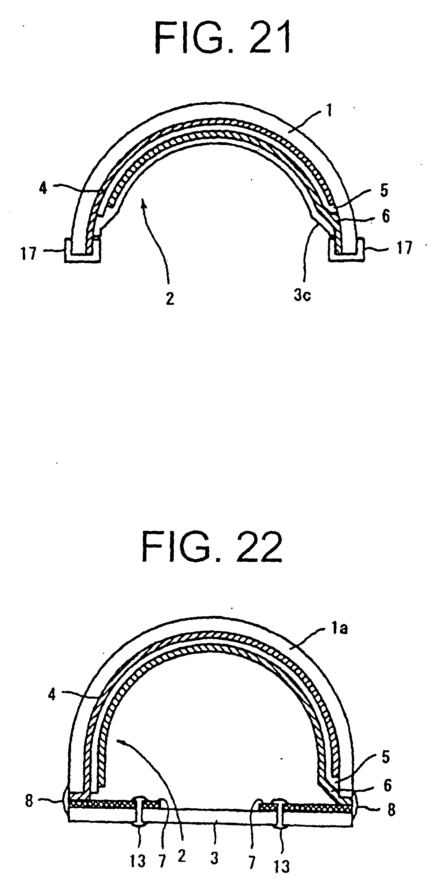

Fig. 21 is a sectional view showing the constitution of another example of the light emitting apparatus in accordance with the present invention. The constitution of the light emitting apparatus in Fig. 21 is the same as that of the light emitting apparatus in Fig. 20 excepting the point that conductive terminals 17 of metal or the like are used as the electrical connection terminals.

As the light emitting apparatus shown in Fig. 20 and Fig. 21, in the case where the opposing substrate is brought into contact with the EL light emitting laminated body, a protective film formed from moisture impermeable material may be used as the opposing substrate. As an example of the material for forming the protective film, SiO, SiO₂, GeO, MoO₃ and the like are available. The protective film may be formed by means of a known method such as vacuum evaporation or sputtering. Applying a moisture impermeable bonding agent, which is used for joining between the warped substrate and the opposing substrate, on the EL light emitting laminated body may form the protective film.

Fig. 22 is a sectional view showing the constitution of another example of the light emitting apparatus in accordance with the present invention. The inner surface of a warped substrate 1a of the light emitting apparatus in Fig. 22 comprises a half spherical surface and a cylindrical surface, which is extended from the edge portion of the half spherical surface. The constitution of the light emitting apparatus in Fig. 22 is the same as that of the light emitting apparatus in Fig. 14 excepting the point that the configuration of the warped substrate is different therefrom.

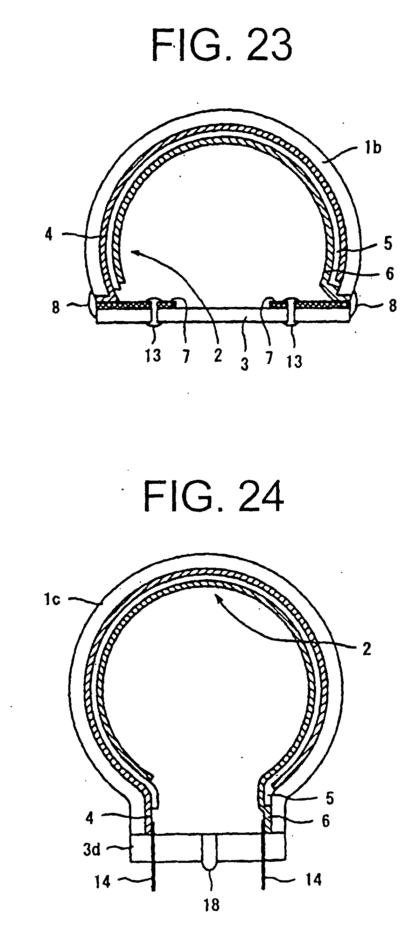

Fig. 23 is a sectional view showing the constitution of another example of the light emitting apparatus in accordance with the present invention. The inner surface of a warped substrate 1b of the light emitting apparatus in Fig. 23 is constituted of a surface, which includes more than the half of the spherical surface. The constitution of the light emitting apparatus in Fig. 23 is the same as that of the light emitting apparatus in Fig. 14 excepting the point that the configuration of the warped substrate is different therefrom.

Fig. 24 is a sectional view showing the constitution of another example of the light emitting apparatus in accordance with the present invention. A warped substrate 1c of the light emitting apparatus in Fig. 24 has a configuration similar to that of a glass bulb of an incandescent bulb. Provided to the light emitting apparatus in Fig. 24 are lead wires 14, which are provided to the openings, which penetrates the opposing substrate 3d, as the electrical connection terminals. The warped substrate 1c and the opposing substrate 3d are joined to each other by means of welding. The warped substrate 1c and the opposing substrate 3d may be joined to each other by means of a bonding agent. After the warped substrate 1c and the opposing substrate 3d have been joined to each other, in order to exhaust the air containing moisture in a space, which is formed by the warped substrate and the opposing substrate, an exhaust opening 18 is provided to the opposing substrate. The exhaust opening 18 is welded to seal the same after the air containing moisture has been exhausted from the space, which is formed by the warped substrate 1c and the opposing substrate 3d.

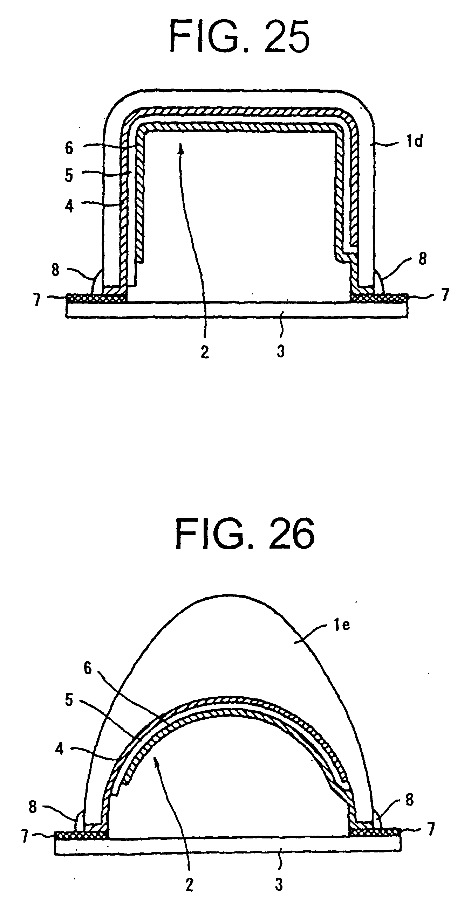

Fig. 25 is a sectional view showing the constitution of another example of the light emitting apparatus in accordance with the present invention. The warped substrate 1d of the light emitting apparatus in Fig. 25 has a cubic configuration of which one surface is opened. The constitution of the light emitting apparatus in Fig. 25 is the same as that of the light emitting apparatus in Fig. 2 excepting the point that the configuration of the warped substrate is different therefrom. As another example of the configuration of the warped substrate, a cylindrical configuration, of which one end is closed, is available.

Fig. 26 is a sectional view showing the constitution of another example of the light emitting apparatus in accordance with the present invention. As shown in Fig. 26, by setting the thickness of the warped substrate 1e, the directivity of the light emitted by the EL light emitting laminated body 2 can be adjusted. The constitution of the light emitting apparatus in Fig. 26 is the same as that of the light emitting apparatus in Fig. 2 excepting the point that the configuration of the warped substrate is different therefrom.

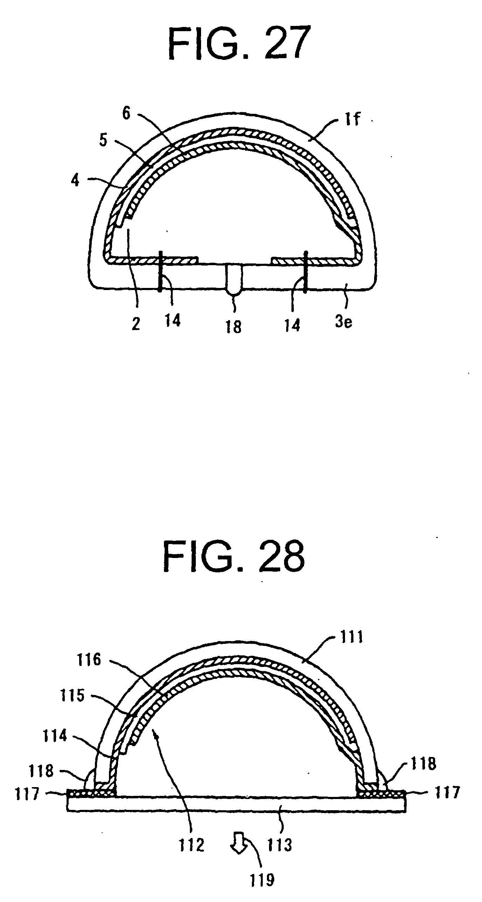

Fig. 27 is a sectional view showing the constitution of another example of the light emitting apparatus in accordance with the present invention. In the light emitting apparatus in Fig. 27, a warped substrate 1f and an opposing substrate 3e are previously formed integrally. As the electrical terminals of the light emitting apparatus in Fig. 27, the lead wires 14 provided to the openings, which penetrate the opposing substrate 3e, are used. Each of the electrode layers and the lead wires are connected electrically to each other being in contact with each other. The exhaust opening 18 is welded to seal the same after the air containing moisture has been exhausted from the light emitting apparatus, or after the air containing moisture has been exhausted therefrom and the same has been filled with an inert gas.

The light emitting apparatus shown in Fig. 2 to Fig. 27, which satisfy the above-described condition (1), have such advantage that the quantity of light per space necessary for installation thereof is large. To make use of such advantage, these light emitting apparatus may be used in place of a bulb for illumination. Recently, investigations on the organic light emitting material used for organic electro-luminescent element have been made actively. And also, organic EL light emitting elements, which have a high light emitting efficiency exceeding the incandescent bulb, have been reported (for example, OYO BUTURI, Vol.70, No.11 (2001)).

There is a case where incandescent bulb is attached with a reflection shade for reflecting the light emitted by the bulb. In the case where the light emitting apparatus of the present invention is used in place of the bulb, there may be such case that the light reflected by the reflection shade hits the light emitting apparatus itself causing a shadow. In order to prevent such shadow from being caused, in the light emitting apparatus of the present invention, it is preferred that the second electrode layer is transparent; the visible light transmittance in the direction perpendicular to the laminated member of the electro-luminescent light emitting laminated body is 50% or more; and the opposing substrate is transparent. EL light emitting laminated body may be formed in the same manner as the transmission type plane EL light emitting element, which has a high visible light transmittance. Japanese Unexamined Patent Publication No. 10-125469 and the like disclose the transmission type plane EL light emitting element.

When the directivity of the light, which is emitted from the light emitting apparatus of the present invention, has to be further adjusted, it is preferred that the second electrode layer is transparent, the visible light transmittance in the direction perpendicular to the laminated member of the electro-luminescent light emitting laminated body is 50% or more, and the opposing substrate has the visible light reflecting property. To provide the visible light reflecting property to the opposing substrate, the opposing substrate is formed from a metal, or a reflection film is formed on the surface of the warped substrate side of the opposing substrate. As an example of the reflection film, a metal film, dielectric multi-film and the like are available. By forming the surface of the warped substrate side of the opposing substrate into a convex or concave surface, the directivity of the light, which is output from the light emitting apparatus, can be further adjusted.

### [Light emitting apparatus that satisfies the condition (2)]

A light emitting apparatus, which satisfies the above condition (2), will be described using the attached drawings (Fig. 28 to Fig. 54).

Fig. 28 is a sectional view showing the constitution of another example of the light emitting apparatus in accordance with the present invention. The light emitting apparatus in Fig. 28 comprises a moisture impermeable substrate 111 (referred to as warped substrate) having a warped configuration, an EL light emitting laminated body 112 formed on the inner surface of the warped substrate 111 and an opposing substrate 113, which is moisture impermeable and joined at the edge portion of the warped substrate 111 in an impermeable manner, and the like.

The EL light emitting laminated body 112 has such constitution that, from the warped substrate 111 side, a negative electrode layer (first electrode layer) 114, a light emitting layer (light emitting function layer) 115 and a positive electrode layer (second electrode layer) 116 are laminated in this order. In order to output the light emission of the EL light emitting laminated body 112 from the opposing substrate 113 side, the positive electrode layer 116 and the opposing substrate 113 are transparent.

The light emitting apparatus is provided with conductive films 117, which are connected to each of a negative electrode layer 114 and a positive electrode layer 116 of the EL light emitting laminated body 112 as the electrical connection terminals for externally supplying the electrical energy to each of the electrode layers. The negative electrode layer 114 (or positive electrode layer 116) is in contact with the conductive film 117 being electrically connected therewith. The warped substrate 111 and the opposing substrate 113 are joined in an impermeable manner with a bonding agent 118.

Same as the light emitting apparatus, which satisfies the above condition (1), the light emitting apparatus in Fig. 28 generates a large quantity of light per space necessary for installation thereof; has a high light emitting efficiency; and the directivity of the light emission and the color of the emitted light can be easily set. As shown in Fig. 28, the light emitting apparatus, which satisfies the condition (2), has a constitution suitable for adjusting the directivity of the light emission to be high in order to output light emission from the inner surface (surface at the positive electrode layer 116 side) of the concave light emitting layer 115.

In the light emitting apparatus in Fig. 28, the light emitting function layer is comprised of a single layer of the light emitting layer 115. The light, which is emitted from the light emitting layer 115 of the organic EL light emitting laminated body 112, passes through the positive electrode layer (second electrode layer) 116, and the opposing substrate 113, and is output to the outside of the light emitting apparatus. The arrowhead 119 marked in Fig. 28 indicates the direction of the output light. Since the light emitting layer 115 has such configuration warped in a concave shape, the directivity of the light output from the light emitting apparatus is increased.

In order to reduce the degradation in the light emitting characteristics of the EL light emitting laminated body 112 due to the absorption of moisture, the warped substrate 11 is formed from a moisture impermeable material. The warped substrate may be transparent or opaque.

The material for forming the transparent warped substrate is the same as that of the warped substrate of the light emitting apparatus, which satisfies the above condition (1). It is preferred that the warped substrate is opaque, and further preferably, the same is opaque and has the visible light reflecting property. As for an example of the material for forming the warped substrate, which is opaque and has the visible light reflecting property, a metal such as aluminum, copper, iron and stainless steel and alloy compositions are available. By employing a metal or alloy composition, the substrate can be precisely processed into a warped configuration. And further, it is possible to reflect the light from the light emitting layer toward the warped substrate side resulting in an increased amount of the light output from the light emitting apparatus.

The directivity of the light emission of the light emitting apparatus in accordance with the present invention is easily adjustable by setting the configuration of the inner surface of the warped substrate. It is preferred that the inner surface of the warped substrate has a configuration including a part of spherical, elliptic or parabolic surface.

In the case of the light emitting apparatus in Fig. 28, the inner surface of the warped substrate 111 has a half-spherical surface. The directivity of the light emission of the light emitting apparatus can be easily adjusted by changing the curvature of the half-spherical surface.

In order to reduce the degradation in the light emitting characteristics of the EL light emitting laminated body 112 due to the absorption of moisture, the opposing substrate 113 is formed from a moisture impermeable material. And in order to output the light emission of the EL light emitting laminated body from the opposing substrate side of the light emitting apparatus, the opposing substrate 113 is formed from a transparent material.

The material for forming the opposing substrate is the same as that of the warped substrate of the light emitting apparatus, which satisfies the condition (1). The visible light transmittance of the opposing substrate is preferably 70% or more; further preferably 80% or more; still further preferably 90% or more.

In order to reduce the moisture absorption of the EL light emitting laminated body, the opposing substrate 113 is joined in an impermeable manner at the edge portion of the warped substrate. In the light emitting apparatus in Fig. 28, the warped substrate 111 and the opposing substrate 113 are joined in an impermeable manner with a bonding agent 118. The kind of the preferred bonding agent and the joining method using the bonding agent are the same as those in the case of the light emitting apparatus in Fig. 2. Same as the light emitting apparatus in Fig. 2, it is preferred to provide a vacuum space or a space filled with an inert gas between the EL light emitting laminated body 112 and the opposing substrate 113.

The EL light emitting laminated body 112 is formed in the same manner as the plane-shaped EL light emitting element excepting the warped configuration.

The EL light emitting laminated body 112 in Fig. 28 has such constitution that, from the warped substrate 111 side, the negative electrode layer (first electrode layer) 114, the light emitting layer (light emitting function layer) 115 and the positive electrode layer (second electrode layer) 116 are laminated in this order. The EL light emitting laminated body 112 may have such constitution that, in the reversed order of the above; i.e., from the warped substrate 111 side, the positive electrode layer (first electrode layer), the light emitting layer (light emitting function layer) and the negative electrode layer (second electrode layer) are laminated in this order. In any constitution, in order to output the light emission of the EL light emitting laminated body from the opposing substrate side of the light emitting apparatus, the second electrode layer is transparent. The first electrode layer may be transparent or opaque. However, in order to output the light emission of the organic EL light emitting laminated body 112 effectively from the opposing substrate 113 side of the light emitting apparatus, it is preferred that the first electrode layer is opaque and has the visible light reflecting property. It is preferred that the EL light emitting laminated body 112 has such constitution that, from the warp 111 side, the negative electrode layer, the light emitting layer and the positive electrode layer are laminated in this order.

In the case where the first electrode layer is constituted of the negative electrode layer, the negative electrode layer is formed from a metal, alloy composition, conductive compound, or mixture thereof, which has a small work function (less than 4eV). As an example of the material for forming the negative electrode layer, metals such as Al, Ti, In, Na, K, Mg, Li, rare earth metal, and alloy compositions such as Na-K alloy, Mg-Ag alloy, Mg-Cu alloy and Al-Li alloy are available. Also, the negative electrode layer may be formed from Al/Al₂O₃ mixture.

When the first electrode layer is the positive electrode layer, the positive electrode layer is formed from a metal, alloy composition, conductive compound or mixture thereof and the like having a large work function (4eV or more). As an example of the material for forming the positive electrode layer, metals such as Au, Ag, Cu, Pt, Ni, V, Pd, alloy composition including the above metals, and transparent conductive compounds such as ITO (indium tin oxide), IZO (indium zinc oxide), CuI, poly (3-methylthiophene), polythienylenevinylene, andpolyaniline are available. As for the positive electrode layer, a nesa film such as SnO₂, CdO, ZnO, TiO₂, and In₂O₃ are available. Also, the positive electrode layer may be formed from a metal having a small work function. As for the metal as described above, metals included in 5-family or 6-family in the periodic table are available; particularly it is preferred to use Cr, Mo, W, Ta, or Nb. Japanese Unexamined Patent Publication No. 2001-43980 discloses a plane-shaped EL light emitting element, in which a metal having a small work function is used for the positive electrode layer.

Depending on the material constituting the warped substrate, for example, when the warped substrate is formed from a transparent material such as glass, if the visible light transmittance of the first electrode layer of the EL light emitting laminated body is high, there may be a case that the natural light and the like enters into the inside of the light emitting apparatus from the warped substrate side. Further, the light emitted by the EL light emitting laminated body may leak from the warped substrate side resulting in such problem that the light cannot be utilized effectively. Accordingly, it is preferred that first electrode layer of the light emitting apparatus has the light impermeability. It is further preferred that the first electrode layer is opaque and has the visible light reflecting property. When the first electrode layer has the visible light reflecting property, the first electrode layer reflects the light from the light emitting layer 115 to the warped substrate 111 side and the directivity of the light is adjusted. Thus the light, which is emitted from the light emitting layer, can be utilized effectively.

The wording "light impermeability" means that the transmittance of the visible light is not more than 30%.

When the first electrode layer has the light impermeability, it is preferred that the visible light transmittance is not more than 30%, further preferably not more than 20%, and further preferably not more than 10%. To form the first electrode layer having the light impermeability, the first electrode layer is formed from the above-described metal or alloy composition. Or, the first electrode layer is formed from a material other than the above; and further, a black layer is formed on the surface of the warped substrate side of the first electrode layer.

When the first electrode layer has the visible light reflecting property, it is preferred that the visible light reflectance thereof is 70% or more, further preferably 80% or more, and further preferably 90% or more. By forming the first electrode layer from a metal or alloy composition, the first electrode layer is opaque and has the visible light reflecting property.

The visible light transmittance (or visible light reflectance) is adjustable by selecting the material for forming the first electrode layer and by increasing/reducing the thickness of the first electrode layer. The thickness of the first electrode 114 is generally not more than 1µm, preferably not more than 200nm. The resistance of the first electrode layer 114 is preferably not more than several hundreds Ω/sq.

When the first electrode layer has the visible light reflecting property, there may be a case where the natural light and the like, which enters into the inside of the light emitting apparatus from the opposing substrate, is reflected by the first electrode layer, and when the light emitting apparatus is turned off, such reflected light is seen. In the case where such reflected light is readily seen at the installation position of the light emitting apparatus, it is preferred that the first electrode layer with the light impermeability, which is provided with above-described black layer, is employed. Owing to the black layer as described above, the light from the light emitting layer toward the warped substrate side is absorbed. Accordingly, the reflection such as the above-described natural light can be reduced.

As for a typical example of the material for forming the black layer, a carbon is available. Also, in place of the carbon, Cr₂O₃, Pr₂O₅, NiO, Mn₂O₅, MnO₂ or the like, which are black semi-conductive oxides may be employed. Japanese Unexamined Patent Publication No. 10-162959 discloses electrode layer, which is formed with such black layer.

When the first electrode layer is formed from a metal or alloy composition, by setting the thickness thereof to be not more than several 10nm, preferably in a range of 3 to 10nm, and further preferably in a range of 3 to 8nm, the first electrode layer has the visible light transmitting property. By employing an extremely thin film formed from a metal and the like as described above as the first electrode layer, and by forming a black layer same as the above to the warped substrate side of the first electrode layer, even when a metal material or alloy composition is employed, the reflection of the natural light and the like in the first electrode layer can be reduced. The electrode layer of which visible light transmitting property is increased by being formed thinly from a metal or the like is employed in a light transmissible type plane-shaped EL light emitting element, of which two electrode layers (positive electrode layer and negative electrode layer) of the EL light emitting element are transparent. Japanese Unexamined Patent Publication No. 10-125469 discloses a transmission type plane-shaped EL light emitting element. Also, between the first electrode layer formed from a metal or the like into an extremely thin film and the black layer, a transparent conductive film may be formed to reduce the resistance of the first electrode layer. The transparent conductive film may be formed from the same material as that for the transparent second electrode layer, which will be described later. Particularly, it is preferred that the film is formed from ITO (indium tin oxide) or IZO (indium zinc oxide).

In the light emitting apparatus in Fig. 28, the light emitting function layer of the EL light emitting laminated body 112 is constituted of a single layer of the light emitting layer 115. The material and forming method for forming the light emitting layer 115 are the same as those for the light emitting apparatus, which satisfies the above condition (1).

In order to output the light emission of the EL light emitting laminated body 112 from the opposing substrate 113 side of the light emitting apparatus, the second electrode layer is transparent.

When the second electrode layer is the positive electrode layer, the positive electrode layer is formed from a metal, alloy composition, conductive compound, or mixture thereof or the like, which have a large work function (4eV or more). As an example of the material for forming the positive electrode layer, a transparent conductive compound such as ITO (indium tin oxide), IZO (indium zinc oxide), CuI, poly (3-methylthiophene), polythienylenevinylene, polyaniline and the like are available. As the positive electrode layer, a nesa film such as SnO₂, CdO, ZnO, TiO₂, In₂O₃ may be employed. As the material for forming the positive electrode layer, it is preferred to employ ITO (indium tin oxide) or IZO (indium zinc oxide). Also, when the positive electrode layer is formed from a metal or alloy composition, in order to form the electrode layer to be transparent, it is necessary to arrange the thickness thereof to be thin as described above. The example of the metal or alloy composition is the same as the case of the positive electrode layer used for the first electrode layer. In order to reduce the resistivity of the positive electrode layer, a transparent conductive film may be formed on the surface at the side opposite to the light emitting function layer of the positive electrode layer.

When the second electrode layer is the negative electrode layer, the negative electrode layer is formed from a metal, alloy composition, conductive compound, mixture thereof or the like having a small work function (less that 4eV). When the negative electrode layer is formed from a metal or an alloy composition, the thickness thereof has to be thin so that the electrode layer is transparent. The example of the material for forming the negative electrode layer is the same as that of the negative electrode layer used for the first electrode layer. Also, Japanese Unexamined Patent Publication No. 10-125469 and Japanese Unexamined Patent Publication No. 2001-176670 disclose respectively a light transmissible type plane-shaped EL light emitting element, in which two electrode layers (positive electrode layer and negative electrode layer) of the EL light emitting element is transparent. The negative electrode layer is formed in the same manner as the transparent negative electrode layer of the light transmissible type plane-shaped EL light emitting element. The Japanese Unexamined Patent Publication No. 2001-176670 discloses that the transparent negative electrode layer of the plane-shaped EL light emitting element may be formed from an ITO (indium tin oxide), IZO (indium zinc oxide) or the like.

It is preferred that the visible light transmittance of the second electrode layer 116 is preferably 70% or more, further preferably 80% or more, still further preferably 90% or more. The visible light transmittance can be adjusted by selecting the material for forming the second electrode layer or by increasing/reducing the thickness of the second electrode layer. The thickness of the second electrode layer 116 is generally not more than 1µm, more preferably not more than 200nm. It is preferred that the resistance of the second electrode layer 116 is preferably not more than several hundreds Ω/sq.

When the second electrode layer 116 is formed, there may be a case where molecule of the material for forming the electrode layer 116 collides with the light emitting layer 115 and damages the light emitting layer. Particularly, when the second electrode layer is formed by means of sputtering, the damage given to the light emitting layer is large. Due to the damage given when the second electrode layer is formed as described above, such problem that the light intensity of the light emission of the EL light emitting laminated body is decreased may be caused. In order to protect the light emitting layer from such damage, a buffer layer may be formed between the second electrode layer 116 and the light emitting layer 115. As the material for forming the buffer layer, an acetylacetonate complex or derivative thereof is available. The central metal of the acetylacetonate complex is preferably an alkali metal, alkaline earth metal, or transition metal. As the material for forming the buffer layer, it is particularly preferred to employ a nickel bisacetylacetonate. As for the buffer layer, Japanese Unexamined Patent Publication No. 2001-176670 discloses the descriptions thereof.

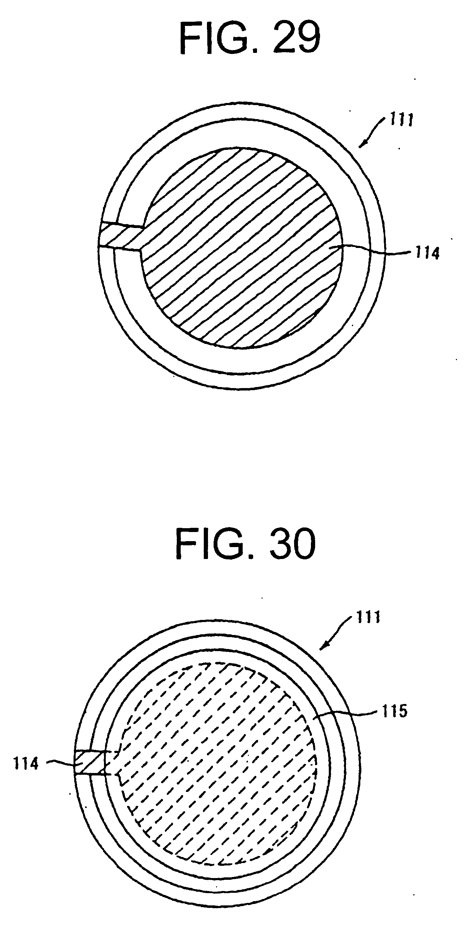

Fig. 29 is a bottom view of the warped substrate 111 in which the negative electrode layer (first electrode layer) 114 has been formed in the fabricating process of the light emitting apparatus in Fig. 28. As shown in Fig. 29, the negative electrode layer 114 is formed on the inner surface of the warped substrate 111. In order to be connected electrically with the conductive film (electrical connection terminal), which is formed on the opposing substrate, a part of the pattern of the negative electrode layer 114 is extended to the edge portion of the warped substrate 111. The pattern of the negative electrode layer 114 is formed in the following manner. That is, a metal foil is attached to a portion, which is not formed with the negative electrode layer of the warped substrate 111; and on the inner surface of the warped substrate attached with the metal foil, a thin film, which is constituted of the material for forming the above negative electrode layer, is formed; and then, the metal foil is removed. Also, in place of the metal foil, a mask, which is formed with an opening of a pattern of the negative electrode layer in a metal plate having a configuration along the inner surface of the warped substrate, may be used. As an example of the forming method of the negative electrode layer, vacuum evaporation, DC sputtering, RF sputtering, spin coating, casting, LB method and the like are available.

Fig. 30 is a bottom view of the warped substrate 111 in which the light emitting layer (light emitting function layer) 115 has been formed after the negative electrode layer 114 in the fabricating process of the light emitting apparatus in Fig. 28. As shown in Fig. 30, the light emitting layer 115 is formed so as to cover substantially all over the negative electrode layer 114 so that the negative electrode layer 114 does not come into contact with the positive electrode layer, which is formed later. The pattern of the light emitting layer 115 is formed in the same manner as that of the negative electrode layer. As an example of the forming method of the light emitting layer, vacuum evaporation, spin coating, casting, LB method and the like are available.

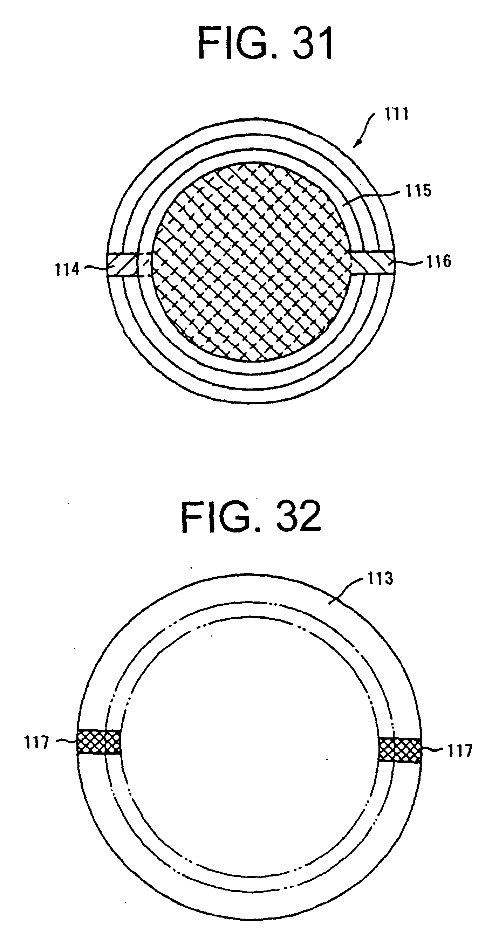

Fig. 31 is a bottom view of the warped substrate 111, in which the positive electrode layer (second electrode layer) 116 has been formed after the light emitting layer 115 in the fabricating process of the light emitting apparatus in Fig. 28. As shown in Fig. 31, the positive electrode layer 116 is formed with a pattern, which does not overlap with the exposed portion of the negative electrode layer so that the same does not come into contact with the negative electrode layer 114. The setting method of the pattern of the positive electrode layer 116 and the forming method of the positive electrode layer are the same as that of the negative electrode layer. Thus, the EL light emitting laminated body is formed on the inner surface of the warped substrate 111.

Fig. 32 is a plan view of the opposing substrate 113 in which the conductive films 117 (electrical connection terminals) have been formed in the fabricating process of the light emitting apparatus in Fig, 28. The conductive films 117 (electrical connection terminals) are formed from a conductive material. As an example of the conductive material, the material for forming the above-described positive electrode layer or the negative electrode layer, and metal materials such as aluminum, copper, silver are available. It is preferred that the conductive film 117 is formed from a transparent conductive material so as not to intercept the light emitted from the EL light emitting laminated body. The forming method of the conductive film 117 is the same as that of the negative electrode layer. When the opposing substrate 113 has a plane shape, the pattern of the conductive film 117 can be formed in a known method (masking, making photolithography or the like). At the position indicated with the two-dot chain lines on the opposing substrate 113 in Fig. 32, the edge portion of the warped substrate, which has been formed with the EL light emitting laminated body, is placed, and the periphery of the joint portion is joined with a bonding agent in an impermeable manner. Thus, the light emitting apparatus in Fig. 28 is obtained.

In order to increase the light emitting efficiency and injecting efficiency of the carrier (hole or electron) to the light emitting layer, it is preferred that the light emitting function layer of the EL light emitting laminated body is constituted of the light emitting layer and the hole transport layer and/or electron transport layer, which are formed being in contact with the light emitting layer.

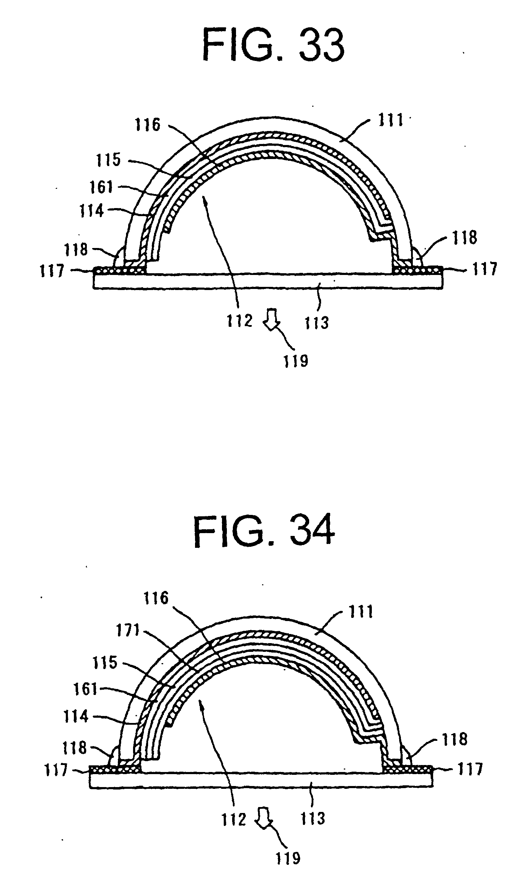

Fig. 33 is a sectional view showing the constitution of another example of the light emitting apparatus in accordance with the present invention. The EL light emitting laminated body 112 of the light emitting apparatus in Fig. 33 has such constitution that, from the warped substrate 111 side, the negative electrode layer 114, an electron transport layer 161, the light emitting layer 115 and positive electrode layer 116 are laminated in this order.

Fig. 34 is a sectional view showing the constitution of another example of the light emitting apparatus in accordance with the present invention. The EL light emitting laminated body 112 of the light emitting apparatus in Fig. 34 has such constitution that, from the warped substrate 111 side, the negative electrode layer 114, the electron transport layer 161, the light emitting layer 115, a hole transport layer 171, and the positive electrode layer 116 are laminated in this order.

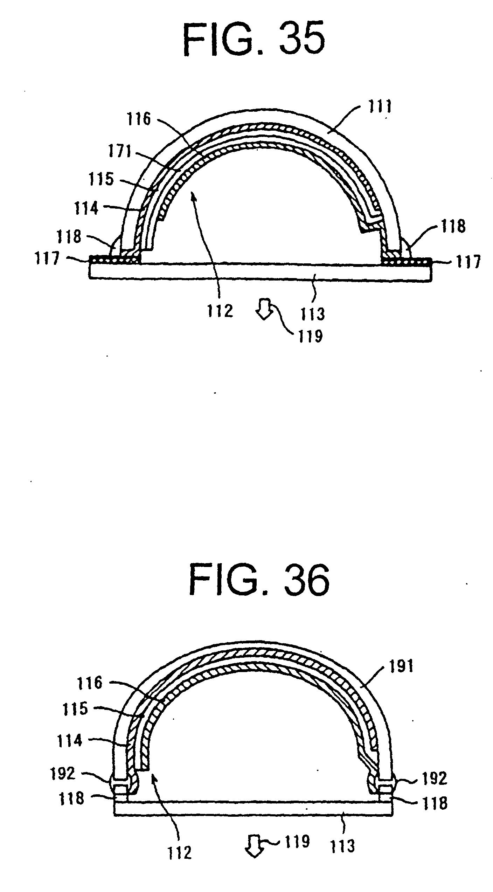

Fig. 35 is a sectional view showing the constitution of another example of the light emitting apparatus in accordance with the present invention. The EL light emitting laminated body 112 of the light emitting apparatus in Fig. 35 has such constitution that, from the warped substrate 111 side, the negative electrode layer 114, the light emitting layer 115, the hole transport layer 171, and the positive electrode layer 116 are laminated in this order.

The electron transport layer 161 and the hole transport layer 171 are formed in the same manner as the light emitting apparatus, which satisfies the above-described condition (1). Between the hole transport layer 171 and the second electrode layer 116, the above-described buffer layer may be formed.

Fig. 36 is a sectional view showing the constitution of another example of the light emitting apparatus in accordance with the present invention. The inner surface of the warped substrate 191 of the light emitting apparatus in Fig. 36 has a configuration, which includes a part of the elliptic surface.

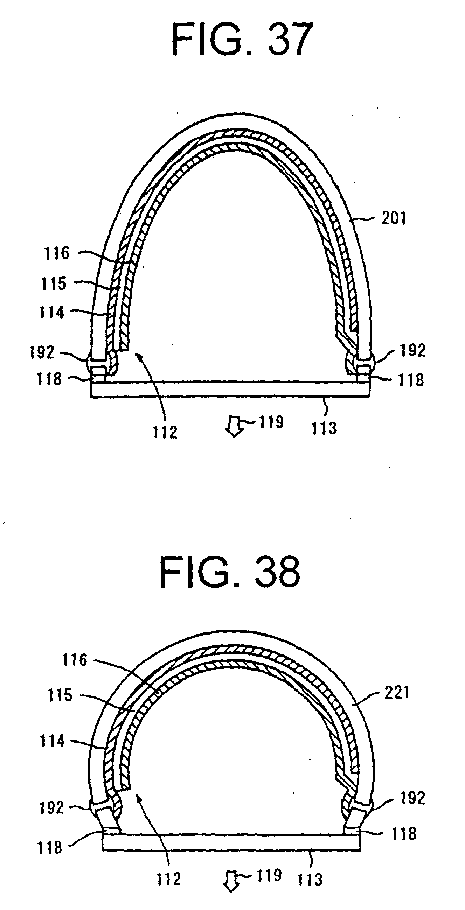

Fig. 37 is a sectional view showing the constitution of another example of the light emitting apparatus in accordance with the present invention. The inner surface of the warped substrate 201 of the light emitting apparatus in Fig. 37 has a configuration, which includes a part of a parabolic surface.

As shown in Fig. 36 and Fig. 37, the inner surface of the warped substrate has a configuration, which includes a part of elliptic surface or parabolic surface; thereby the directivity of the light, which is output from the opposing substrate side of the light emitting apparatus, can be adjusted.

Formed to the light emitting apparatus shown in Fig. 36 and Fig. 37 are conductive terminals 192 as the electrical connection terminals, which are provided in the openings penetrating the warped substrate in an airtight manner. The electrical connection terminals 192 are formed from a conductive material such as metal. As the light emitting apparatus shown in Fig. 36 and Fig. 37, when the warped substrate (191 or 201) and the opposing substrate 113 are joined via the bonding agent 118, the bonding agent 118 is applied thinly in thickness; thereby the amount of the moisture, which enters into the inside of the light emitting apparatus through the joint portion between the warped substrate and the opposing substrate, can be reduced.

Also, in the light emitting apparatus of the present invention, by setting the configuration of the warped substrate, the quantity of light, which is output from the light emitting apparatus, can be adjusted. For example, to increase the quantity of light, which is output from the light emitting apparatus, the area of the EL light emitting laminated body formed on the inner surface of the warped substrate per area of the opposing substrate is increased.

Fig. 38 is a sectional view showing the constitution of another example of the light emitting apparatus in accordance with the present invention. The inner surface of the warped substrate 211 of the light emitting apparatus in Fig. 38 is constituted of a half spherical surface and a cylindrical surface, which is extended from the edge portion of the half spherical surface. By forming the warped substrate 211 into such configuration, the area of the EL light emitting laminated body 112 per area of the opposing substrate 113 becomes larger than that of the light emitting apparatus in Fig. 28; thus it is possible to generate a large quantity of light, which is output from the light emitting apparatus.

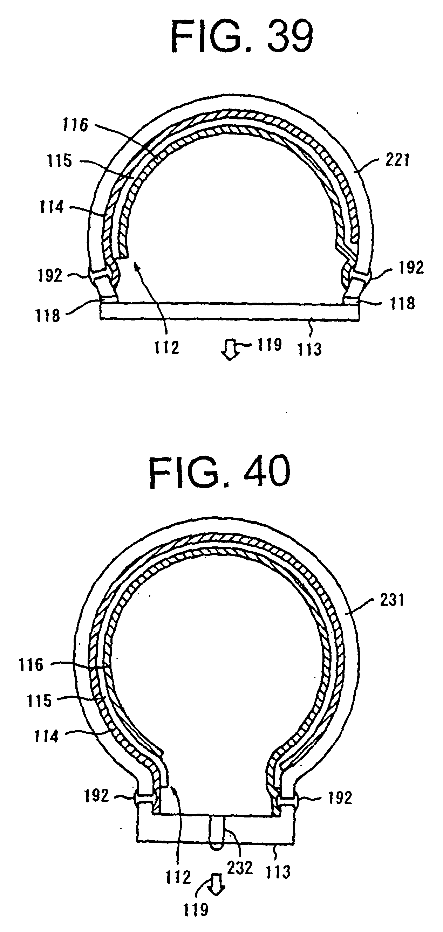

Fig. 39 is a sectional view showing the constitution of another example of the light emitting apparatus in accordance with the present invention. The inner surface of the warped substrate 221 of the light emitting apparatus in Fig. 39 is constituted of the surface, which includes more than half of the spherical surface. The constitution of the light emitting apparatus in Fig. 39 is the same as that of the light emitting apparatus in Fig. 38 excepting the point that the configuration of the warped substrate is different therefrom.

Fig. 40 is a sectional view showing the constitution of another example of the light emitting apparatus in accordance with the present invention. The inner surface of the warped substrate 231 of the light emitting apparatus in Fig. 40 is constituted of a surface, which includes half or more of the spherical surface and a cylindrical surface, which is extended from the edge portion of the surface. As the light emitting apparatus in Fig. 40, the warped substrate 231 and the opposing substrate 113 may be previously formed integrally. After the air containing moisture has been exhausted from the light emitting apparatus, or after the air has been exhausted therefrom, and then, filled with an inert gas therein, the exhaust opening 232 is welded to seal the same.

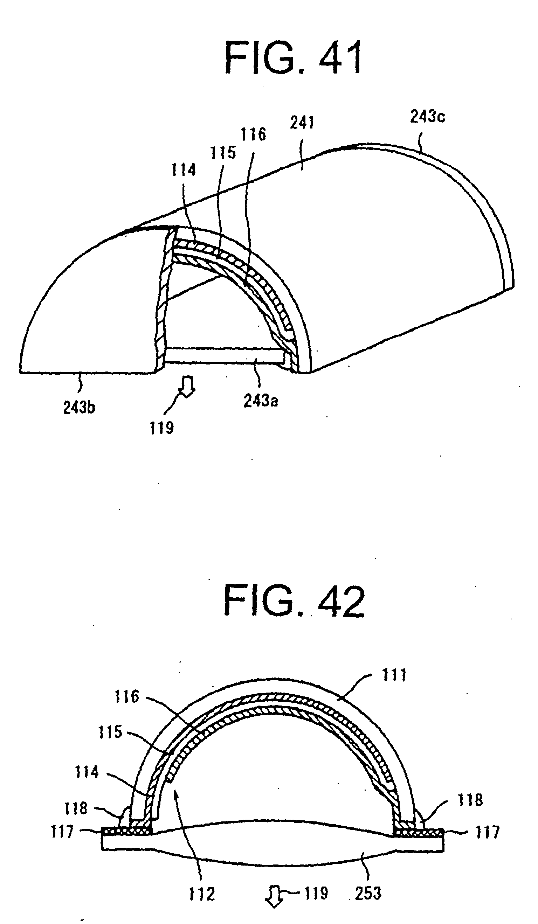

Fig. 41 is a partially broken perspective view showing the constitution of another example of the light emitting apparatus in accordance with the present invention, in which a part thereof is removed. As shown in Fig. 41, in the edge portion of the warped substrate of the light emitting apparatus of the present invention, in addition to the opposing substrate, an impermeable member for sealing the EL light emitting laminated body may be joined thereto. In the light emitting apparatus in Fig. 41, in the edge portion of the warped substrate 241, an opposing substrate 243a and impermeable members 243b and 243c are joined thereto. The impermeable members 243b and 243c may be formed from an impermeable transparent material same as the opposing substrate. In the case where it is not necessary to output the light from the impermeable member, the impermeable members 243b and 243c may be formed from a moisture impermeable opaque material. An example of the material for forming the impermeable member is the same as that of the warped substrate and opposing substrate.

Next, the configuration of the opposing substrate will be described. As described above, in the light emitting apparatus of the present invention, by setting the configuration of the warped substrate, the directivity of the light emission can be easily adjusted. However, by setting the configuration of the opposing substrate, the directivity of the light emission can be further adjusted.

Fig. 42 is a sectional view showing the constitution of another example of the light emitting apparatus in accordance with the present invention. The opposing substrate 253 of the light emitting apparatus in Fig. 42 is adjusted in the thickness to form a convex lens. Owing to the convex lens formed on the opposing substrate 253, the directivity of the light, which output from the light emitting apparatus, can be further adjusted. The constitution of the light emitting apparatus in Fig. 42 is the same as that of the light emitting apparatus in Fig. 28 excepting the point that the configuration of the opposing substrate is different therefrom. The opposing substrate may be adjusted in the thickness thereof to form a concave lens.

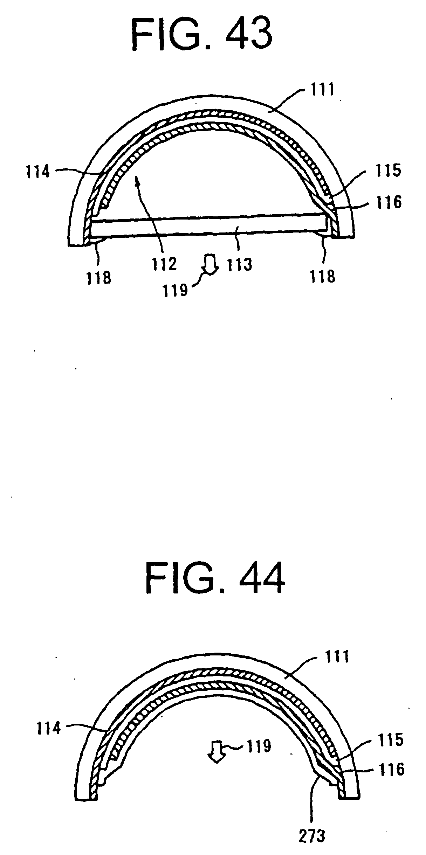

Fig. 43 is a sectional view showing the constitution of another example of the light emitting apparatus in accordance with the present invention. As shown in Fig. 43, the opposing substrate may be joined with the warped substrate in a region adjacent to the edge portion thereof. The opposing substrate 113 of the light emitting apparatus in Fig. 43 is joined to the warped substrate 111 in a region adjacent to the edge portion thereof by means of the bonding agent 118. As the electrical connection terminals of the light emitting apparatus, the negative electrode layer 114 and the positive electrode layer 116, which are provided at the joint portion between the warped substrate 111 and the opposing substrate 113, are used.

Fig. 44 is a sectional view showing the constitution of another example of the light emitting apparatus in accordance with the present invention. As shown in Fig. 44, the light emitting apparatus of the present invention may have such configuration that the opposing substrate is in contact with the EL light emitting laminated body. As shown in Fig. 44, EL light emitting laminated body and the opposing substrate 273 of the light emitting apparatus are in contact with each other. As the electrical connection terminals of the light emitting apparatus, the negative electrode layer 114 and the positive electrode layer 116, which are provided at the joint portion between the warped substrate 111 and the opposing substrate 273, are used.

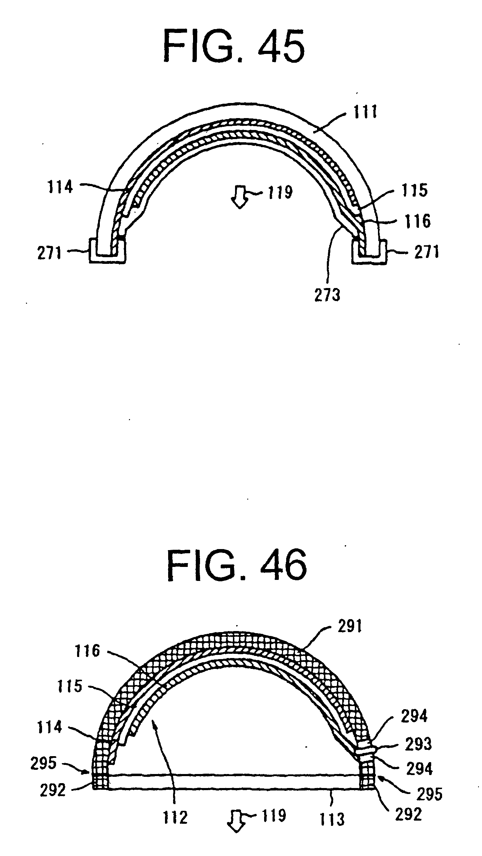

Fig. 45 is a sectional view showing the constitution of another example of the light emitting apparatus in accordance with the present invention. The constitution of the light emitting apparatus in Fig. 45 is the same as that of the light emitting apparatus in Fig. 44 excepting the point that the conductive terminals 271 formed from a metal or the like are used as the electrical connection terminals.

When the opposing substrate is formed being in contact with the EL light emitting laminated body, as the opposing substrate, a protective film formed from moisture impermeable material may be used. The protective film may be formed in the same manner as that of the light emitting apparatus, which satisfies the above condition (1).

In the light emitting apparatus of the present invention, in order to make the space, which is formed by the warped substrate and the opposing substrate, airtight state, it is preferred that, at each edge portion of the warped substrate and the opposing substrate or in a region adjacent to the edge portion, joint portions formed from a metal or alloy composition are provided, and these joint portions are welded to join the warped substrate and the opposing substrate to each other.

Fig. 46 is a sectional view showing the constitution of another example of the light emitting apparatus in accordance with the present invention. The warped substrate 291 of the light emitting apparatus in Fig. 46 is formed from a metal. On the other hand, on the edge portion of the opposing substrate 113, joint portion 292 formed from a metal is provided. The warped substrate, which is formed with the EL light emitting laminated body 112, and the opposing substrate, which is provided with joint portion 292, are joined by means of welding at the welding area 295.

The warped substrate 291 and the negative electrode layer 114 are connected electrically; and the warped substrate is used as the electrical connection terminal of the negative electrode layer. As the electrical connection terminal of the positive electrode layer 116, a conductive terminal 293 provided to an opening, which penetrates the warped substrate 291, is used. The conductive terminal 293 is electrically insulated from the warped substrate 291 by an insulating material 294. As an example of the material for forming the insulating material 294, polyimide resin, acrylic resin, glass and the like are available.

In the conventional plane-shaped EL light emitting element, a glass substrate formed with EL light emitting element and a cap formed from glass and the like are joined by means of a bonding agent; thereby the EL light emitting element is sealed in an airtight manner. The reason why the glass substrate, which is formed with the EL light emitting element, and the cap are not welded is as described below. That is, to carry out welding, the joint portion has to be heated up to a temperature exceeding the softening point of the glass (approximately 700°C, depending on the kind of the glass); and owing to the welding heat, organic matter included in the EL light emitting element is oxidized or decomposed causing the light emitting characteristics to be decreased.

The EL light emitting laminated body 112 of the light emitting apparatus in Fig. 46 is sealed by welding the metal, which forms the warped substrate 291 and the metal, which forms the joint portion 292, provided to the opposing substrate 113. Such welding between the metals, compared to the case where the welding is made between the glasses, can be carried out at a lower temperature in a shorter period of time.

As an example of the method for welding metal or alloy composition at a low temperature and in a short period of time, ultrasonic welding, pressure welding, resistance welding, high frequency induction welding, and high frequency resistance welding and the like are available. As for the method of such welding, detailed information is given in "Metal handbook" 4th revision (MARUZEN) and the like. A region adjacent to the welding area 295 of joint portion 292 provided to the opposing substrate and the warped substrate 291 may be changed in shape (for example, welding margin and the like may be formed).

Before the opposing substrate and the warped substrate are joined to each other, the opposing substrate 113 and the welding area 292 can be previously joined to each other at a high temperature in an impermeable manner. When glass is employed as the opposing substrate, it is preferred that the joint portion is formed from a metal or alloy composition, which has the thermal expansion coefficient close to the value of the glass and satisfactory wetting characteristics. The glass for forming the opposing substrate is softened and welded to the joint portion. Also, the opposing substrate 113 and the welding area 292 may be joined using a hot cure type bonding agent, which has low moisture permeability.

As an example of the material for forming the joint portion, Fe, Fe-Ni alloy, Fe-Ni-Cr alloy, and Fe-Ni-Co alloy and the like are available. It is preferred that a copper thin film is formed on the surface of the joint portion, which is formed from the above material. Further, another method, in which glass and metal or the like are joined to each other using a granulated glass (called as frit glass), is known. As for the joining method between glass and metal, detailed descriptions are given in "GLASS OPTICS HANDBOOK"(ASAKURA, 1999) and the like.

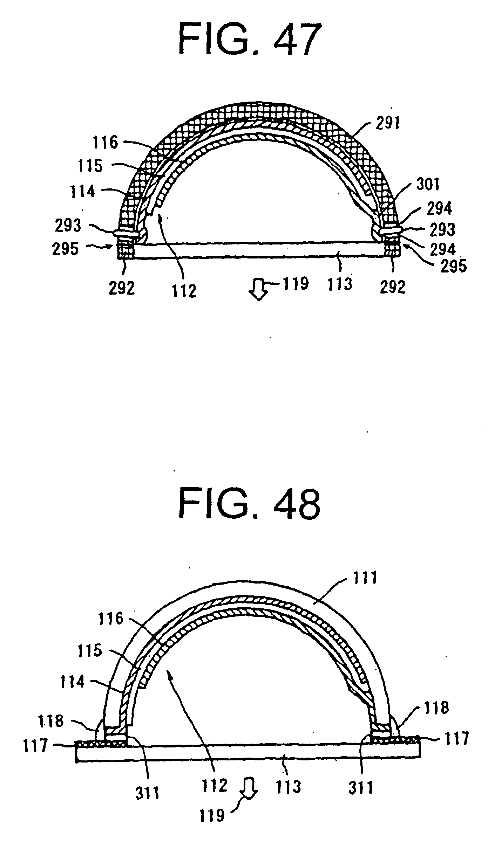

Fig. 47 is a sectional view showing the constitution of another example of the light emitting apparatus in accordance with the present invention. The joint portion 292 and the warped substrate 291 of the light emitting apparatus in Fig. 47 are, same as the light emitting apparatus in Fig. 46, formed from a metal, and are joined to each other by means of welding. When the warped substrate 291 is formed from a metal, as shown in Fig. 47, an insulation film 301 may be formed on the inner surface of the warped substrate 291. By forming the insulation film 301, the electrical connection terminal 293 of the light emitting apparatus may be formed in any position in the warped substrate. The insulation film 301 may be formed any material of polyimide resin, acrylic resin, glass and the like, which has the electrical insulation performance.

Fig. 48 is a sectional view showing the constitution of another example of the light emitting apparatus in accordance with the present invention. The constitution of the light emitting apparatus in Fig. 48 is the same as that of the light emitting apparatus in Fig. 28, excepting the point that each of the electrode layers and the conductive films 117, which are used as the electrical connection terminals, are connected electrically via a conductive bonding material 311 respectively. By employing the conductive bonding material 311, a satisfactory electrical connection between each of the electrode layer and the conductive films 117 can be obtained. As an example of the conductive bonding material 311, conductive bonding agent, in which binder resin is densely mixed with conductive filler, anisotropic conductive film, anisotropic conductive paste, silver paste, copper paste and the like are available. When the moisture permeability of the conductive bonding material 311 is satisfactorily low, the bonding agent 118 for reducing the moisture permeability in the area of the conductive bonding agent 311 is not necessary.

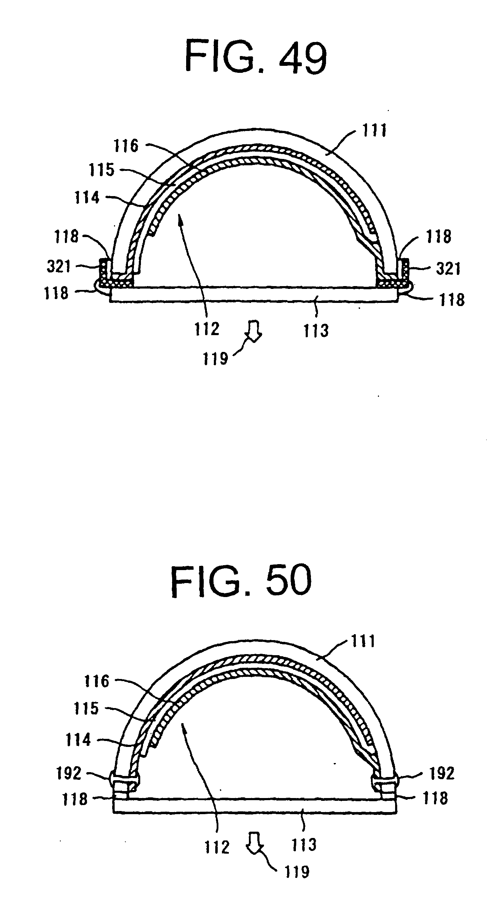

Fig. 49 is a sectional view showing the constitution of another example of the light emitting apparatus in accordance with the present invention. The constitution of the light emitting apparatus in Fig. 49 is the same as that of the light emitting apparatus in Fig. 28 excepting the point that, as the electrical connection terminals, metal foils 321, which are provided to the joint portion between the warped substrate 111 and the opposing substrate 113 are used. The negative electrode layer 114 (or positive electrode layer 116) and the metal foil 321, which is used as the electrical connection terminal, are connected electrically being in contact with each other. The above may be electrically connected to each other via a conductive bonding material same as the light emitting apparatus in Fig. 48.

Fig. 50 is a sectional view showing the constitution of another example of the light emitting apparatus in accordance with the present invention. In the light emitting apparatus in Fig. 50, after the EL light emitting laminated body 112 has been formed on the inner surface of the warped substrate 111, openings, which penetrate the warped substrate, are formed. As the electrical connection terminals, conductive terminals (electrical connection terminals) 192, which are formed of metal and the like, are attached to these openings.

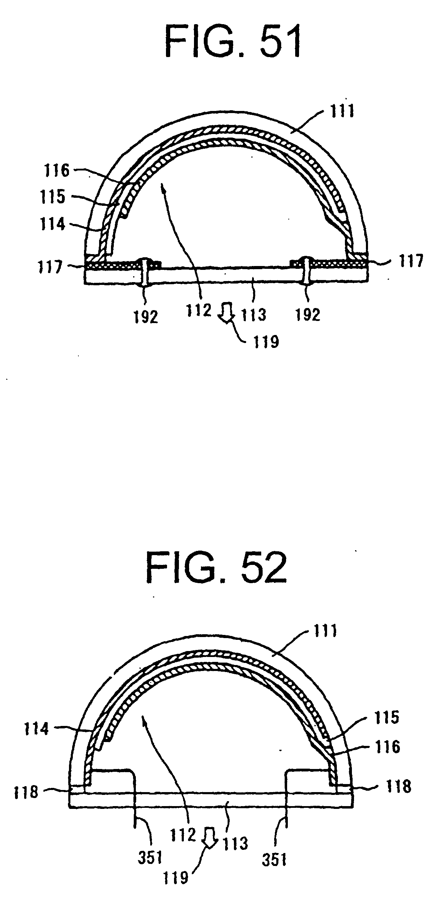

Fig. 51 is a sectional view showing the constitution of another example of the light emitting apparatus in accordance with the present invention. As the electrical connection terminals of the light emitting apparatus in Fig. 51, conductive terminals 192, which are provided to the openings, which penetrate the opposing substrate 113, are used. Each of the electrode layer and the conductive terminals 192 are connected electrically via conductive films 117, which are formed on the surface of the opposing substrate 113. It is preferred that, as the conductive films 117, a transparent conductive film is employed so as not to interfere the light, which is emitted from the EL light emitting laminated body 112. The transparent conductive film may be formed from a transparent material same as the second electrode layer. It is preferred that the conductive terminals 192 are provided at a position as closer to the edge portion of the opposing substrate 113 as possible.

Fig. 52 is a sectional view showing the constitution of another example of the light emitting apparatus in accordance with the present invention. The constitution of the light emitting apparatus in Fig. 52 is the same as the light emitting apparatus in Fig. 50 excepting the point that, as the electrical connection terminals, lead wires 351 provided to the openings, which penetrate the opposing substrate 113, are used. Each of the electrode layers and the lead wires 351 are connected electrically being in contact with each other.

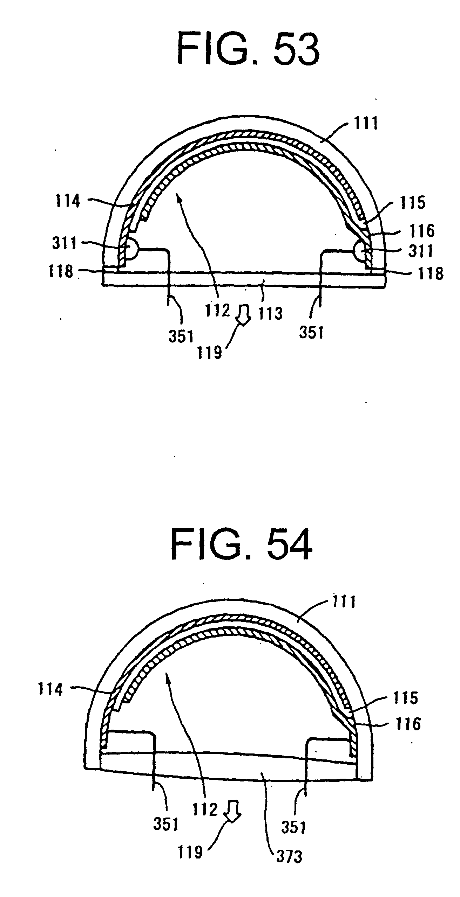

Fig. 53 is a sectional view showing the constitution of another example of the light emitting apparatus in accordance with the present invention. The constitution of the light emitting apparatus in Fig. 53 is the same as that of the light emitting apparatus in Fig. 52 excepting the point that the each of the electrode layers and the lead wires 351 are connected electrically via the conductive bonding material 311.

Fig. 54 is a sectional view showing the constitution of another example of the light emitting apparatus in accordance with the present invention. The constitution of the light emitting apparatus in Fig. 54 is the same as that of the light emitting apparatus in Fig. 52 excepting that point that the warped substrate 111 and the opposing substrate 373 provided with lead wires (electrical connection terminals) 351 are joined to each other in a region adjacent to the edge portion of the warped substrate. The opposing substrate 373 is formed with a convex lens for adjusting the directivity of the light emission.

### [Light emitting apparatus that satisfies condition (3)]

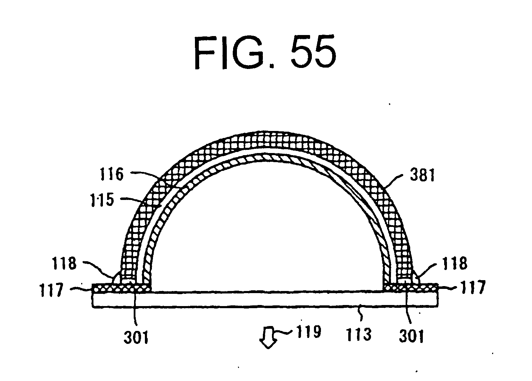

Fig. 55 is a sectional view showing the constitution of still another example of the light emitting apparatus in accordance with the present invention. The light emitting apparatus in Fig. 55 is comprised of an electro-luminescent light emitting laminated body constituted of the light emitting layer 115 and the second electrode layer 116 being laminated on the inner surface of the warped metal substrate in this order, the moisture impermeable opposing substrate 113, which is joined to the edge portion of the warped metal substrate 381 in an impermeable manner, and the conductive films 117 (electrical connection terminals), which are connected to the second electrode layer 116, for externally supplying electrical energy to the electrode layer 116. The warped metal substrate 381 functions as the other electrode layer of the EL light emitting laminated body and as electrical connection terminal of this electrode layer. Also, the light emitting function layer of the light emitting apparatus in Fig. 55 is constituted of a single layered light emitting layer 115. In order to output the light emission of the EL light emitting laminated body from the opposing substrate 113 side of the light emitting apparatus, the second electrode layer 116 and the opposing substrate 113 are transparent.

The light emitting apparatus in Fig. 55 has such advantage that the step of forming the first electrode layer of the EL light emitting laminated body can be eliminated. The warped metal substrate 381 may be the positive electrode or the negative electrode, and may be formed using a metal or alloy composition out of the materials for forming the first electrode layer of the light emitting apparatus that satisfies the above condition (2).

Further, same as the light emitting apparatus in Fig. 46, a joint portion may be formed in the periphery of the opposing substrate, and the metal or alloy composition, which forms the warped metal substrate, and the metal or alloy composition, which forms the joint portion provided to the opposing substrate, may be joined by means of welding.

The light emitting apparatus that satisfies the condition (2) or (3), which has been described using Fig. 28 to Fig. 55, has a large quantity of light per space necessary for installation, allows easy adjustment of the directivity of light emission and easy arrangement of the color of emitted light and has a high light emitting efficiency. The light emitting apparatus as described above is applicable to indicator lamps, spotlights and backlight of liquid display devices and the like.

### [Brief Description of the Drawings]

Fig. 1 is a sectional view showing the constitution of an example of a conventional light emitting apparatus;
Fig. 2 is a sectional view showing the constitution of an example of a light emitting apparatus in accordance with the present invention;
Fig. 3 is a bottom view of the warped substrate in which a positive electrode layer has been formed in the fabricating process of the light emitting apparatus in Fig. 2;
Fig. 4 is a bottom view of the warped substrate in which a light emitting layer has been formed in the fabricating process of the light emitting apparatus in Fig. 2;
Fig. 5 is a bottom view of the warped substrate in which a negative electrode layer has been formed in the fabricating process of the light emitting apparatus in Fig. 2;
Fig. 6 is a plan view of the opposing substrate in which the conductive film has been formed in the fabricating process of the light emitting apparatus in Fig. 2;
Fig. 7 is a sectional view showing the constitution of another example of the light emitting apparatus in accordance with the present invention;
Fig. 8 is a sectional view showing the constitution of another example of the light emitting apparatus in accordance with the present invention;
Fig. 9 is a sectional view showing the constitution of another example of the light emitting apparatus in accordance with the present invention;
Fig. 10 is a sectional view showing the constitution of another example of the light emitting apparatus in accordance with the present invention;
Fig. 11 is a sectional view showing the constitution of another example of the light emitting apparatus in accordance with the present invention;
Fig. 12 is a sectional view showing the constitution of another example of the light emitting apparatus in accordance with the present invention;
Fig. 13 is a sectional view showing the constitution of another example of the light emitting apparatus in accordance with the present invention;
Fig. 14 is a sectional view showing the constitution of another example of the light emitting apparatus in accordance with the present invention;
Fig. 15 is a sectional view showing the constitution of another example of the light emitting apparatus in accordance with the present invention;
Fig. 16 is a sectional view showing the constitution of another example of the light emitting apparatus in accordance with the present invention;
Fig. 17 is a sectional view showing the constitution of another example of the light emitting apparatus in accordance with the present invention;
Fig. 18 is a sectional view showing the constitution of another example of the light emitting apparatus in accordance with the present invention;
Fig. 19 is a sectional view showing the constitution of another example of the light emitting apparatus in accordance with the present invention;
Fig. 20 is a sectional view showing the constitution of another example of the light emitting apparatus in accordance with the present invention;
Fig. 21 is a sectional view showing the constitution of another example of the light emitting apparatus in accordance with the present invention;
Fig. 22 is a sectional view showing the constitution of another example of the light emitting apparatus in accordance with the present invention;
Fig. 23 is a sectional view showing the constitution of another example of the light emitting apparatus in accordance with the present invention;
Fig. 24 is a sectional view showing the constitution of another example of the light emitting apparatus in accordance with the present invention;
Fig. 25 is a sectional view showing the constitution of another example of the light emitting apparatus in accordance with the present invention;
Fig. 26 is a sectional view showing the constitution of another example of the light emitting apparatus in accordance with the present invention;
Fig. 27 is a sectional view showing the constitution of another example of the light emitting apparatus in accordance with the present invention;
Fig. 28 is a sectional view showing the constitution of another example of the light emitting apparatus in accordance with the present invention;
Fig. 29 is a bottom view of the warped substrate in which a negative electrode layer has been formed in the fabricating process of the light emitting apparatus in Fig. 28;
Fig. 30 is a bottom view of the warped substrate in which a light emitting layer has been formed in the fabricating process of the light emitting apparatus in Fig. 28;
Fig. 31 is a bottom view of the warped substrate in which a positive electrode layer has been formed in the fabricating process of the light emitting apparatus in Fig. 28;
Fig. 32 is a plan view of the opposing substrate in which a conductive film has been formed in the fabricating process of the light emitting apparatus in Fig, 28;
Fig. 33 is a sectional view showing the constitution of another example of the light emitting apparatus in accordance with the present invention;
Fig. 34 is a sectional view showing the constitution of another example of the light emitting apparatus in accordance with the present invention;
Fig. 35 is a sectional view showing the constitution of another example of the light emitting apparatus in accordance with the present invention;
Fig. 36 is a sectional view showing the constitution of another example of the light emitting apparatus in accordance with the present invention;
Fig. 37 is a sectional view showing the constitution of another example of the light emitting apparatus in accordance with the present invention;
Fig. 38 is a sectional view showing the constitution of another example of the light emitting apparatus in accordance with the present invention;
Fig. 39 is a sectional view showing the constitution of another example of the light emitting apparatus in accordance with the present invention;
Fig. 40 is a sectional view showing the constitution of another example of the light emitting apparatus in accordance with the present invention;
Fig. 41 is a partially broken perspective view showing the constitution of another example of the light emitting apparatus in accordance with the present invention, in which a part thereof is removed;
Fig. 42 is a sectional view showing the constitution of another example of the light emitting apparatus in accordance with the present invention;
Fig. 43 is a sectional view showing the constitution of another example of the light emitting apparatus in accordance with the present invention;
Fig. 44 is a sectional view showing the constitution of another example of the light emitting apparatus in accordance with the present invention;
Fig. 45 is a sectional view showing the constitution of another example of the light emitting apparatus in accordance with the present invention;
Fig. 46 is a sectional view showing the constitution of another example of the light emitting apparatus in accordance with the present invention;
Fig. 47 is a sectional view showing the constitution of another example of the light emitting apparatus in accordance with the present invention;
Fig. 48 is a sectional view showing the constitution of another example of the light emitting apparatus in accordance with the present invention;
Fig. 49 is a sectional view showing the constitution of another example of the light emitting apparatus in accordance with the present invention;
Fig. 50 is a sectional view showing the constitution of another example of the light emitting apparatus in accordance with the present invention;
Fig. 51 is a sectional view showing the constitution of another example of the light emitting apparatus in accordance with the present invention;
Fig. 52 is a sectional view showing the constitution of another example of the light emitting apparatus in accordance with the present invention;
Fig. 53 is a sectional view showing the constitution of another example of the light emitting apparatus in accordance with the present invention;
Fig. 54 is a sectional view showing the constitution of another example of the light emitting apparatus in accordance with the present invention; and
Fig. 55 is a sectional view showing the constitution of another example of the light emitting apparatus in accordance with the present invention.

Next, the present invention will be described specifically while giving examples.

### [EXAMPLE 1]

### [Forming of positive electrode layer]

A half spherical glass of 10mm in outer diameter and 1mm in thickness is used as the warped substrate. An aluminum foil is attached to a portion of the inner surface of the warped substrate, which is not formed with positive electrode layer, so that the positive electrode layer of a pattern shown in Fig, 3 is formed. ITO (indium tin oxide) thin film of 0.15µm in thickness is formed by means of sputtering on the inner surface of the warped substrate to which the aluminum foil is attached. The aluminum foil, which has been attached to the warped substrate, is removed; thereby the thin film pattern is formed as the positive electrode layer. As for the thickness of the positive electrode layer, a sample for measuring film thickness, which has been formed with ITO thin film on the warped substrate, is processed under the same conditions as the above, and the section of the positive electrode layer is observed using a scanning electron microscope to measure the thickness.

### [Forming of hole transport layer]

1g of o-dichlorobenzene (organic solvent) are dosed with 2mg of carbonate-based copolymer shown below (carrier transporting material) and agitated with a magnetic stirrer; thus an embrocation for forming hole transport layer is prepared.

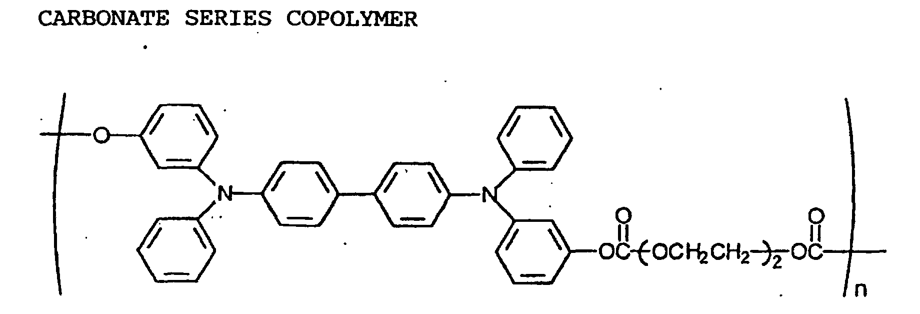

In a portion of the inner surface of the warped substrate formed with a positive electrode layer, where hole transport layer is not formed, an aluminum foil is attached to form a hole transport layer having the same pattern as the light emitting layer shown in Fig. 4. The warped substrate, to which the aluminum foil is attached, is secured on the turntable of the spin coater using a double-faced adhesive tape so that the edge portion of the warped substrate comes to the top. Then, the above embrocation for forming hole transport layer is dropped onto the inner surface of the warped substrate using a dropper. Then, the turntable of the spin coater is turned at a revolution speed of 3500rpm to spin coat the embrocation for forming hole transport layer on the inner surface of the warped substrate, which has been formed with the positive electrode layer. The warped substrate, which has been applied with the embrocation for forming hole transport layer, is heated at a temperature of 80°C for 20 minutes, and then at a temperature of 120°C for 20 minutes using an oven to dry the same. The thickness of the hole transport layer is measured using a scanning electron microscope in the same manner as the above. The thickness is 50nm.

### [Forming of light emitting layer]

In the state that the aluminum foil, which has been used for forming the hole transport layer, is attached, a thin film of an Alq₃ (tris 8-hydroxyquinolinato) aluminum) as the organic light emitting material is formed on the inner surface of the warped substrate by means of vacuum evaporation. And then, aluminum foil, which has been attached to the warped substrate, is removed. Thus, the hole transport layer and the light emitting layer are formed into the same pattern. The thickness of the light emitting layer is measured using a scanning electron microscope in the same manner as the above. The thickness is 50nm.

### [Forming of negative electrode layer]

An aluminum foil is attached to a portion where is not formed with the negative electrode layer in the inner surface of the warped substrate, which has been formed with the light emitting layer to form the negative electrode layer having the pattern shown in Fig, 5. Then, an MgAg alloy thin film of 200nm in thickness is formed by means of vacuum evaporation on the inner surface of the warped substrate to which the aluminum foil has been attached. And then, by removing the aluminum foil, which has been attached to the warped substrate, the pattern of the thin film is formed as the negative electrode layer. Thus, the electro-luminescent light emitting laminated body constituted of the positive electrode layer, the hole transport layer, the light emitting layer and the negative electrode layer is formed on the inner surface of the warped substrate.

### [Fabricating of opposing substrate]

As the opposing substrate, a disk-like glass plate of 1mm in thickness and 12mm in diameter is used. On the glass plate, a mask of stainless, which has openings with a pattern of the conductive film shown in Fig. 6, is disposed in contact therewith, and an ITO thin film of 0.15µm in thickness is formed by means of sputtering. By removing the mask from the glass plate, the opposing substrate formed with the conductive films (electrical connection terminals) is fabricated.

On the surface of the fabricated opposing substrate, which has been formed with the conductive film, the warped substrate, which has been formed with the electro-luminescent light emitting laminated body is placed so that the portions formed with the positive electrode layer and the negative electrode layer on the edge portion of the warped substrate come into contact with the conductive film of the opposing substrate. And a bonding agent is applied to the periphery of the joint portion between the warped substrate and the opposing substrate to join the same to each other in an impermeable manner. Thus, the light emitting apparatus of the present invention is fabricated. A voltage of 11V is applied to the conductive film (electrical connection terminal) of the fabricated light emitting apparatus to measure the brightness of the emitted light. The brightness is 14400cd/m². The color of the emitted light of the fabricate light emitting apparatus is green.

### [EXAMPLE 2]

In the same manner as the example 1, on the inner surface of the warped substrate, the positive electrode layer having a pattern shown in Fig, 3 is formed. An aluminum foil is attached to a portion where is not formed with the light emitting layer in the inner surface of the warped substrate, which has been formed with the positive electrode layer, so that the light emitting layer having a pattern shown in Fig. 4 is formed.

1.25g of o-dichlorobenzene (organic solvent) is dosed with 25mg of carbonate-based copolymer (hole transporting material), which is used in example 1, 36mg of PBD (electron transporting material), which is expressed by the following chemical formula, and 0.61g of coumarin 6 (organic light emitting material), and agitated with a magnetic stirrer; thus an embrocation for forming the light emitting layer is prepared.

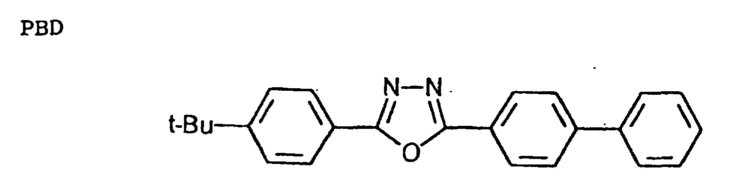

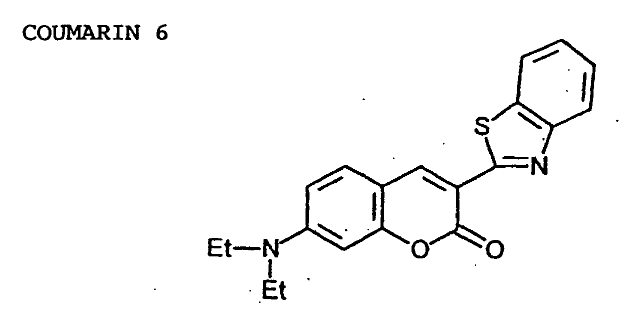

Then, the warped substrate, to which the aluminum foil is attached, is secured on the turntable of the spin coater using a double-faced adhesive tape so that the edge portion of the warped substrate comes to the top. Then, the prepared embrocation for forming light emitting layer is dropped onto the inner surface of the warped substrate using a dropper. Then, the turntable of the spin coater is turned at a revolution speed of 3000rpm to spin coat the embrocation for forming light emitting layer on the inner surface of the warped substrate, which has been formed with the positive electrode layer. The warped substrate, which has been applied with the embrocation for forming light emitting layer, is heated at a temperature of 80°C for 20 minutes, and then at a temperature of 120°C for 20 minutes using an oven to dry the same. Then, the aluminum tape attached to the warped substrate is removed, and thus a thin film pattern as the light emitting layer is formed. The thickness of the light emitting layer is measured using a scanning electron microscope in the same manner as the above. The thickness is 50nm.

On the inner surface of the warped substrate, which has been formed with the light emitting layer, the negative electrode layer having a pattern shown in Fig, 5 is formed in the same manner as the example 1. Thus, on the inner surface of the warped substrate, the electro-luminescent light emitting laminated body comprised of the positive electrode layer, the light emitting layer and the negative electrode layer are formed. The light emitting apparatus is fabricated in the same manner as the example 1 excepting the point that the obtained warped substrate is used. A voltage of 22V is applied to the electrical connection terminals of the fabricated light emitting apparatus to measure the brightness of the emitted light. The brightness is 480cd/m². The color of the emitted light of the fabricated light emitting apparatus is green.

### [Example 3]

The positive electrode layer is formed on the inner surface of the warped substrate in the same manner as the example 1. In a portion of the inner surface of the warped substrate formed with a positive electrode layer, where is not formed with hole transport layer, an aluminum foil is attached so that a hole transport layer having the same pattern as the light emitting layer shown in Fig. 4 is formed. On the inner surface of the warped substrate, which has been attached with the aluminum foil, a thin film of TPD (triphenyldiamine), which is a hole transporting material, is formed by means of vacuum evaporation. The thickness of the hole transport layer is measured using a scanning electron microscope in the same manner as the above. The thickness is 50nm.

After that, the light emitting layer and the negative electrode layer are formed in the same manner as the example 1. Thus, on the inner surface of the warped substrate, the electro-luminescent light emitting laminated body comprised of the positive electrode layer, the hole transport layer, the light emitting layer, and the negative electrode layer is formed.

The light emitting apparatus is fabricated in the same manner as the example 1 excepting the point that the obtained warped substrate is used. A voltage of 10V is applied to the electrical connection terminals of the fabricated light emitting apparatus to measure the brightness of the emitted light. The brightness is 2100cd/m². The color of the emitted light of the fabricated light emitting apparatus is green.

### [Industrial Applicability]

The light emitting apparatus of the present invention has a large quantity of light per space necessary for installation, allows easy adjustment of the directivity of light emission and easy arrangement of the color of emitted light and has a high light emitting efficiency. Particularly, the light emitting apparatus of the present invention is preferably employed as a light source of indicator lamps.

## Claims

1. A light emitting apparatus comprising:
a moisture impermeable substrate having a warped configuration;
an electro-luminescent light emitting laminated body formed on the inner surface of the warped substrate having such constitution that, from the warped substrate side, at least a first electrode layer, a light emitting function layer and a second electrode layer being laminated in order;
a moisture impermeable opposing substrate joined in an impermeable manner at an edge portion or in a region adjacent to the edge portion of said warped substrate; and
electrical connection terminals connected to each of the electrode layers of said electro-luminescent light emitting laminated body for externally supplying electrical energy to each electrode layer.

2. The light emitting apparatus according to claim 1, wherein the warped substrate is transparent, the first electrode layer is transparent, the second electrode layer is either transparent or opaque, and the opposing substrate is either transparent or opaque.

3. The light emitting apparatus according to claim 1, wherein the warped substrate is either transparent or opaque, the first electrode layer is either transparent or opaque, the second electrode layer is transparent, and the opposing substrate is transparent.

4. The light emitting apparatus according to claim 1, wherein the warped substrate and the first electrode layer are constituted of a warped metal substrate, the second electrode layer is transparent, and the opposing substrate is transparent.

5. The light emitting apparatus according to claim 2, wherein the second electrode layer is opaque and has a visible light reflecting property.

6. The light emitting apparatus according to claim 2, wherein the second electrode layer is transparent, a visible light transmittance in a direction perpendicular to a laminated member of the electro-luminescent light emitting laminated body is 50% or more, and the opposing substrate is transparent.

7. The light emitting apparatus according to claim 2, wherein the second electrode layer is transparent, a visible light transmittance in a direction perpendicular to a laminated member of the electro-luminescent light emitting laminated body is 50% or more, and the opposing substrate is opaque and has the visible light reflecting property.

8. The light emitting apparatus according to claim 3, wherein the first electrode layer is opaque and has a visible light reflecting property.

9. The light emitting apparatus according to claim 3, wherein the warped substrate is opaque and has a visible light reflecting property.

10. The light emitting apparatus according to claim 9, wherein the warped substrate is constituted of a metal.

11. The light emitting apparatus according to claim 3, wherein the opposing substrate is adjusted in thickness thereof to form either convex lens or concave lens.

12. The light emitting apparatus according to claim 1, wherein the inner surface of the warped substrate has a configuration including a part of any one of a spherical surface, an elliptic surface and a parabolic surface.

13. The light emitting apparatus according to claim 1, wherein the inner surface of the warped substrate has a half spherical surface.

14. The light emitting apparatus according to claim 1, wherein, between the electro-luminescent light emitting laminated body and the opposing substrate, either a vacuum space or a space filled with an inert gas, is formed.

15. The light emitting apparatus according to claim 1, wherein the electro-luminescent light emitting laminated body and the opposing substrate are in contact with each other.

16. The light emitting apparatus according to claim 1, wherein the warped substrate and the opposing substrate, which are provided with a joint portion respectively constituted of either a metal or alloy composition at a position either in each edge portion or in a region adjacent to the edge portion, and these joint portions are welded to join to each other in an impermeable manner.

17. The light emitting apparatus according to claim 1, wherein one of the electrical connection terminals that connect each of the first electrode layer and the second electrode layer of the electro-luminescent light emitting laminated body is provided to a joint portion between the warped substrate and the opposing substrate.

18. The light emitting apparatus according to claim 1, wherein both of the electrical connection terminals that connect each of the first electrode layer and the second electrode layer of the electro-luminescent light emitting laminated body are provided to a joint portion between the warped substrate and the opposing substrate.

19. The light emitting apparatus according to claim 1, wherein one of the electrical connection terminals that connect each of the first electrode layer and the second electrode layer of the electro-luminescent light emitting laminated body is provided to an opening penetrating the warped substrate.

20. The light emitting apparatus according to claim 1, wherein both of the electrical connection terminals that connect each of the first electrode layer and the second electrode layer of the electro-luminescent light emitting laminated body are provided to openings penetrating the warped substrate.

21. The light emitting apparatus according to claim 1, wherein one of the electrical connection terminals that connect each of the first electrode layer and the second electrode layer of the electro-luminescent light emitting laminated body is provided to an opening penetrating the opposing substrate.

22. The light emitting apparatus according to claim 1, wherein both of the electrical connection terminals that connect each of the first electrode layer and the second electrode layer of the electro-luminescent light emitting laminated body are provided to openings penetrating the opposing substrate.

23. The light emitting apparatus according to claim 21, wherein the opposing substrate and the electro-luminescent light emitting laminated body are joined via a conductive material layer.
